# EUROPÄISCHE PATENTANMELDUNG

(11) **EP 0 978 874 A2**
(43) Veröffentlichungstag der Anmeldung: **09.02.2000**
(21) Anmeldenummer: 99114745.5
(22) Anmeldetag: 28.07.1999
(51) Int. Cl.: H01L 23/373, H01L 23/473

(54) **Kühler**

(30) Priorität: 04.08.1998 DE 19835126; 06.08.1998 DE 19835583; 15.10.1998 DE 19847557; 21.11.1998 DE 19853750; 04.06.1999 DE 19925510
(71) Anmelder: Schulz-Harder, Jürgen, Dr.-Ing., 91207 Lauf (DE)
(72) Erfinder: Schulz-Harder, Jürgen, Dr.-Ing., 91207 Lauf (DE)
(74) Vertreter: Graf, Helmut, Dipl.-Ing.

(57) **Zusammenfassung**

Die Erfindung bezieht sich auf einen neuartigen Kühler zur Verwendung als Wärmesenke für elektrische oder elektronische Komponenten, insbesondere Bauelemente, Schaltkreise und Module.

## Beschreibung

Die Erfindung bezieht sich auf einen Kühler gemäß Oberbegriff Patentanspruch 1, 12, 13, 15 oder 19.

Kühler dieser Art, die aus einer Vielzahl von stapelartig übereinander angeordneten Schichten oder Lagen bestehen und zur Verwendung als Wärmesenken für elektrische Bauelemente oder Schaltkreise geeignet sind, sind grundsätzlich bekannt. Bekannt ist hierbei auch die Verwendung von Metall-Lagen, die mittels des sogenannten DCB-Verfahrens (Direct-Copper-Bonding-Technology) miteinander verbunden sind (IBMTDB,1993, Vol. 36, Nr. 11, Seite 291 -293; IBMTDB, 1992, Vol. 35, Nr. 4A, S. 378 - 379).

Vorgeschlagen wurde weiterhin bereits ein Kühler, der aus einer Vielzahl von Kühlerlagen besteht, die durch entsprechende Strukturierung eine dreidimensionale Mikro-Kühlerstruktur bilden, d.h. eine Kühlstruktur, die in drei senkrecht zueinander verlaufenden Raumachsen von einem Kühlmedium durchströmt werden kann (nicht vorveröffentlichte DE 197 10 783.4). Die Praxis hat gezeigt, daß sich die Kühlleistung eines solchen Kühlers trotz Erhöhung der Anzahl der Kühllagen nicht erhöhen läßt, d.h. diejenigen Kühllagen, die einen größeren Abstand von der wenigstens einen Kühlerfläche aufweisen nicht mehr oder nur noch ungenügend zur Kühlung beitragen.

Es wurde bereits versucht, diesen Nachteil dadurch zu beheben, daß bei einem mehrlagigen Kühler die Kühlkanäle kaskadenartig aufeinander folgend vorgesehen und im Gegenstrom vom Kühlmedium durchströmt werden. Hierdurch ergeben sich aber sehr lange Strömungswege und damit ein hoher Strömungswiderstand für das Kühlmedium durch den Kühler.

Aufgabe der Erfindung ist es, einen Kühler aufzuzeigen, der eine verbesserte Kühlleistung ermöglicht.

Zur Lösung dieser Aufgabe ist ein Kühler entsprechend dem Patentanspruch 1, 12, 13, 15 oder 19.ausgebildet. Der erfindungsgemäße Kühler läßt sich einfach und preiswert aus mehreren übereinander gestapelten Kühlerlagen herstellen, die mit einer geeigneten Technik, beispielsweise durch Löten, durch Aktivlöt-Verfahren, durch DCB-Technik usw. miteinander verbunden sind.

Nach einem Aspekt der Erfindung wird durch entsprechende Strukturierung der ersten und/oder zweiten Kühlerlagen erreicht, daß auch bei einer Vielzahl von Lagen das zunächst am Einlaß in Bereichen der Kühlerstruktur mit größerem Abstand von der wenigstens einen Kühlerfläche strömende Kühlmedium bzw. zumindest aber ein größerer Teil hiervon an oder in die Nähe der Kühlerfläche gelenkt wird und dort zur Kühlwirkung beiträgt.

Nach einem anderen Aspekt der Erfindung wird durch Verbreiterung der Durchbrüche an den Kreuzungsstellen der Strukturen eine Reduzierung des Gesamtströmungswiderstandes erreicht, so daß bei gleichem Differenzdruck an dem Kühler ein höherer Durchsatz am Kühlmedium und dadurch eine Steigerung der Kühlwirkung erreicht wird.

Bei einer Ausführung der Erfindung sind zumindest die strukturierten Kühlerlagen solche aus Metall, beispielsweise aus Kupfer, und dann z.B. mit der Direct-Bonding-Technik miteinander verbunden, und zwar bei Kühlerlagen aus Kupfer z.B. speziell mittels der DCB-Technik (Direct Copper Bonding-Technik).

Für die Strukturierung in die Kühlerlagen beispielsweise zumindest in einem Teilbereich siebartig mit einer Vielzahl von Öffnungen und diese Öffnungen umgebende Materialbereichen oder Stegen versehen, wobei beispielsweise bei den zweiten Kühlerlagen der Anteil an geschlossener Fläche zur Fläche der Durchbrechungen oder Öffnungen vom Einlaß zum Auslaß hin zunimmt.

Bei einer Ausführungsform bilden die Öffnungen oder Durchbrechungen eine netzartige Struktur, bei der die Öffnungen von Ringstrukturen oder von durch Stege gebildete Polygon- oder Ringstrukturen umschlossen sind.

Bei einer Ausführungsform weist die Strukturierung der zweiten Kühlerlagen Durchbrechungen oder Öffnungen auf, die zum Auslaß hin im Querschnitt und/oder in der Anzahl reduziert sind.

Bei einer Ausführungsform sind die Strukturierungen der wenigstens einen zweiten Kühlerlage dadurch gebildet, daß die Öffnungen oder Durchbrechungen der wenigstens einen ersten Kühlerlage durch Metallstege, die hinsichtlich ihrer Breite und/oder Anzahl vom Einlaß zum Auslaß hin zunehmen, zumindest teilweise verschlossen sind.

Bei einer Ausführungsform ist die Strukturierung der Kühlerlagen durch schlitzförmige Öffnungen oder Durchbrechungen gebildet, die sich von Kühlerlage zu Kühlerlage kreuzen, wobei die Anzahl und/oder Breite der schlitzförmigen Öffnungen der wenigstens einen zweiten Kühlerlage kleiner ist als die entsprechende Anzahl oder Breite der Öffnungen in der ersten Kühlerlage.

Bei einer Ausführungsform ist die Strukturierung der Kühlerlagen durch schlitzförmige Öffnungen oder Durchbrechungen gebildet, die sich von Kühlerlage zu Kühlerlage kreuzen, wobei sich die Öffnungen in der zweiten Kühlerlage zum Auslaß hin verengen.

Diese vorgenannten Ausführungsformen können auch miteinander kombiniert sein. Bevorzugt sind die Kühlerlagen so strukturiert, daß Flächenbereiche dieser Kühlerlagen sich von Kühlerlage zu Kühlerlage decken und zu Pfosten ergänzen, die sich senkrecht zur Ebene der Lage erstrecken, wobei diese Pfosten beispielsweise in der Kühlerstruktur und/oder in der jeweiligen Verteilerstruktur vorgesehen sind.

Weiterbildungen der Erfindung sind Gegenstand der Unteransprüche. Die Erfindung wird im Folgenden anhand der Figuren an Ausführungsbeispielen näher erläutert. Es zeigen:
- Fig. 1: in sehr vereinfachter Darstellung und in Seitenansicht einen dreidimensionalen Mikro-Kühler gemäß der Erfindung, auch zur Erläuterung der erfindungsgemäßen Ausbildung und Funktionsweise;
- Fig. 2: in Draufsicht eine der normal strukturierten bzw. ersten Metall-Lagen ohne reduzierten effektiven Strömungsquerschnitt zur Herstellung des dreidimensionalen Mikro-Kühlers der Figur 1;
- Fig. 3: in Draufsicht eine der strukturierten zweiten Metall-Lagen mit reduziertem Querschnitt zur Herstellung des dreidimensionalen Mikro-Kühlers der Figur 1;
- Fig. 4: in Draufsicht zwei aufeinander folgende erste Metall-Lagen der Fig. 2;
- Fig. 5: in Draufsicht zwei aufeinander folgende erste und zweite Metall-Lagen der Fig. 2 und 3;
- Fig. 6 und 7: jeweils in Draufsicht strukturierte erste und zweite Metall-Lagen für einen Mikro-Kühler;
- Fig. 8: in Draufsicht zwei aufeinander folgende erste Metall-Lagen der Fig. 6;
- Fig. 9: in Draufsicht zwei aufeinander folgende erste und zweite Metall-Lagen der Fig. 6 und 7;
- Fig. 10 und 11: die untere bzw. obere äußere Abschlußlage eines unter Verwendung der strukturierten Metall-Lagen der Figuren 2/3 und 6/7hergestellten Mikro-Kühlers;
- Fig. 12- 15: in vereinfachter Darstellung und in Draufsicht erste und zweite strukturierte Metall-Lagen für eine weitere mögliche Ausführungsform eines Mikro-Kühlers;
- Fig. 16 und 17: in vereinfachter Darstellung und in Draufsicht zweite strukturierte Metall-Lagen für eine weitere mögliche Ausführungsform eines Mikro-Kühlers;
- Fig. 18: in einer vereinfachten Darstellung und in Seitenansicht einen zu einer Mittelebene symmetrisch ausgebildeter Mikro-Kühler;
- Fig. 19: eine Draufsicht auf eine strukturierte Metall-Lage eines von sich kreuzenden Strukturen gebildeten Mikro-Kühlers:
- Fig. 20: in vergrößerte Darstellung zwei sich kreuzende Metall-Lagen der Figur 19;
- Fig. 21: in einer vereinfachten Darstellung und in Seitenansicht einen Mikro-Kühler;
- Fig. 22 und 23: jeweils in Draufsicht eine strukturierte erste Metall-Lage (Figur 22) bzw. eine strukturierte zweite Metall-Lage (Figur 23) zur Verwendung bei dem Kühler der Fig. 21;
- Fig. 24: einen Schnitt entsprechend der Linie I - I der Figur 22 durch diese erste Metall-Lage und im Kühler darunterliegende Metall-Lagen des Kühlers der Figur 21;
- Fig. 25: einen Schnitt entsprechend der Linie II - II der Figur 22 durch die erste Metall-Lage und darunterliegende Metall-Lagen des Kühlers der Figur 21;
- Fig. 26: einen Schnitt ähnlich der Figur 24 bei einer weiteren möglichen Ausführungsform;
- Fig. 27 und 28: in vereinfachter Darstellung und in Draufsicht eine erste und eine zweite strukturierte Metall-Lage einer weiteren mögliche Ausführungsform eines Mikro-Kühlers;
- Fig. 29: in vergrößerter Teildarstellung eine der Metall-Lagen der Figuren 27 und 28;
- Fig. 30: in vergrößerter Teildarstellung eine erste und eine zweite übereinander angeordnete Metall-Lage der Figuren 27 und 28.

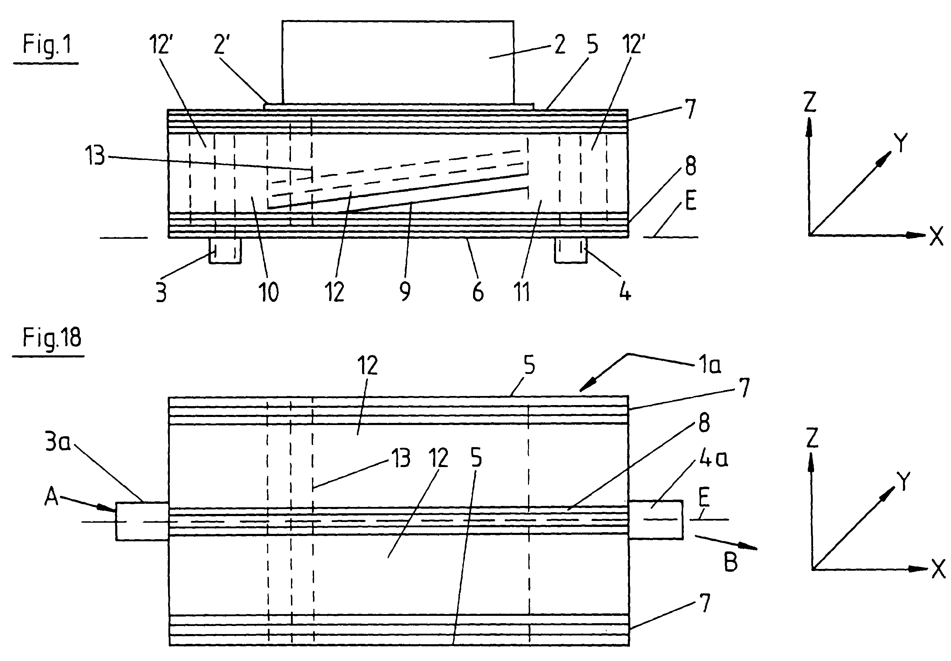

Der In der Figur 1 allgemein mit 1 bezeichnete Kühler (Wärmesenke) dient zum Abführen von Verlust-Wärme (Verlustleistung) eines elektrischen oder elektronischen Bauteils oder Baugruppe, beispielsweise eines Halbleiterleistungs-Bauelementes oder Moduls. Diese elektrische oder elektronische Komponente ist in der Figur 1 allgemein mit 2 bezeichnet.

Der Kühler 1 ist in an sich bekannter Weise mehrlagig ausgeführt, d.h. der besteht aus mehreren Kühlerlagen, z.B. Metall-Lagen, beispielsweise Kupferlagen, die stapelartig übereinander angeordnet und flächig miteinander verbunden sind, und zwar zu dem an den Außenflächen quaderförmig ausgebildeten Kühler 1. In der Figur 1 ist weiterhin mit 3 ein Einlaß für ein Kühlmedium, vorzugsweise für ein flüssiges Kühlmedium, beispielsweise Wasser bezeichnet. Mit 4 ist der Auslaß bezeichnet, an dem das Kühlmedlum bzw. wärmetransportierende Medium den Kühler 1 verläßt.

Zum einfachen Verständnis sind in den Figuren die drei senkrecht zueinander verlaufenden Raumachsen, X-Achse, Y-Achse und Z-Achse angegeben. Die X-Achse, Y-Achse und Z-Achse sind so angenommen, daß die Ober- und Unterseite des Kühlers 1 jeweils in der X-Y-Ebene und die einzelnen, den Kühler bildenden und ebenfalls in der X-Y-Ebene angeordneten Metall-Lagen in Richtung der Z-Achse aufeinander folgen. Die Ebene der Unterseite des Kühlers 1 ist in der Figur 1 mit E bezeichnet. Die X-Y-Ebene der Unterseite des Kühlers 1 ist in der Figur 1 mit E bezeichnet.

Im Inneren des von den Metall-Lagen gebildeten Kühlers 1 sind durch eine nachstehend noch näher beschriebene Strukturierung der einzelnen Metall-Lagen Strömungswege zwischen dem Einlaß 3 und dem Auslaß 4 gebildet, auf denen das Strömungsmedium sich ständig dreidimensional verzweigend, d.h. durch mehrfaches Umlenken in allen drei Raumachsen X-Achse, Y-Achse und Z-Achse den Innenraum des Kühlers 1 bzw. eine dortige Kühlerstruktur 12 durchströmen kann.

Die Praxis hat gezeigt, daß bei einer Ausbildung eines Kühlers, der aus mehreren strukturierten Metall-Lagen, beispielsweise aus strukturierten Kupfer-Lagen besteht, die z.B. eine Dicke in der Größenordnung von 0,3 mm aufweisen, die Kühlwirkung nicht beliebig durch Erhöhung der Anzahl der Metall-Lagen und damit durch Erhöhung der Höhe des Kühlers 1 in der Z-Achse verbessert werden kann. Vielmehr wird nach einer bestimmten Anzahl von Lagen, beispielsweise bei der vorstehend angegebenen Dicke der Metall-Lagen bereits nach mehr als fünf Lagen eine Verbesserung der Kühlwirkung nicht mehr erreicht, da die unteren der Unterseite bzw. Ebene E näherliegenden Metall-Lagen bzw. die durch die dortige Strukturierung gebildeten Strömungswege keinen Beitrag mehr zur Kühlwirkung leisten können.

Gemäß der Erfindung ist daher die Strukturierung der einzelnen, den Kühler 1 bildenden Metall-Lagen 7 und 8 so ausgeführt, daß zumindest im unteren Bereich des Kühlers 1 die dortigen Metall-Lagen 8 eine Strukturierung in der Form aufweisen, daß der Strömungsquerschnitt zumindest in den Ebenen dieser Lagen, d.h. in der X-Achse und Y-Achse und damit der spezifische Strömungswiderstand, d.h. der Strömungswiderstand bezogen auf die Länge und den Querschnitt des Strömungsweges, vom Einlaß 3 zum Auslaß 4 hin zunimmt.

Im einzelnen besteht der Kühler 1 daher aus einer im wesentlichen geschlossenen oberen Metall-Abschlußlage 5, auf der bei der dargestellten Ausführungsform vorzugsweise über eine Zwischenlage 2' aus einem isolierenden Material, beispielsweise über eine Keramiklage die Komponente 2 befestigt ist, aus einer die Unterseite bildenden unteren geschlossenen Metall-Abschlußlage 6, in der die Anschlüsse 3 und 4 vorgesehen sind, und sowie aus einer Vielzahl von strukturierten Metall-Lagen 7 bzw. 8, von denen die oberen, d.h. der oberen Abschlußlage 5 näherliegenden Metall-Lagen 7 im Sinne der vorliegenden Erfindung erste Metall-Lagen mit nicht reduziertem Strömungsquerschnitt und die Metall-Lagen 8, die der Ebene E näher liegen, im Sinne der Erfindung zweite Metall-Lagen mit einem sich zum Auslaß 4 zumindest in der X-Achse und Y-Achse zunehmenden spezifischen Strömungswiderstand sind.

Obwohl in der Figur 1 der besseren Übersichtlichkeit wegen nur die Metall-Lagen 5 und 6 und zwischen diesen nur einige der Metall-Lagen 7 und 8 gezeigt sind, besteht der Kühler 1 selbstverständlich ausschließlich aus solchen stapelartig über einander angeordneten und flächig mit einander verbundenen Metall-Lagen, d.h. zwischen den exemplarisch dargestellten Lagen 7 und 8 befinden sich weitere Metall-Lagen 7 bzw. 8.

Durch diese Ausbildung ergibt sich innerhalb des Kühlers 1 die in der Figur 1 mit den Linien 9 angedeutete Verteilung der Strömung des Kühlmediums, d.h. dasjenige Kühlmedium, welches im Bereich des Einlasses 3 noch in den von den zweiten Lagen 8 bzw. deren Strukturierung in der Nähe der Ebene E gebildeten Strömungswege floß, wird zunehmend in die oberen, der Oberseite des Kühlers 1 bzw. der oberen Abschlußlage 5 benachbarten Lagen 7 verdrängt, und zwar für eine verbesserte Querverteilung des Kühlmediums.

Vorstehend wurde zum einfacheren Verständnis davon ausgegangen, daß die aneinander anschließenden ersten Metall-Lagen 7 und auch die aneinander anschließenden zweiten Metall-Lagen 8 jeweils eine identische Strukturierung aufweisen. Tatsächlich ist dies in der Praxis in der Regel nicht der Fall, d.h. zwei aneinander anschließende Metall-Lagen 7, aber auch zwei aneinander anschließende Metall-Lagen 8 sind unterschiedlich derart strukturiert, daß sich die Strukturen dieser Metall-Lagen nicht decken, sondern beispielsweise um ein Teil-Rastermaß einer solchen Struktur gegeneinander so versetzt sind, daß z.B. einer in einer Metall-Lage 7 bzw. 8 gebildeten Durchbrechung oder Öffnung ein geschlossener Flächenabschnitt einer benachbarten Lage 7 bzw. 8 zumindest teilweise gegenüberliegt, so daß sich keine unmittelbar durchgehenden geradlinigen Strömungswege in Richtung der Z-Achse ergeben, sondern die Strömung in dieser Richtung nur durch mehrfaches Umlenken in der X-Achse und/oder Y-Achse möglich ist. Die Lagen 7 bzw. 8 sind beispielsweise so strukturiert, daß die Struktur zumindest für den die Kühlerstruktur 12 mit den Mikrokanäle bildenden Bereich symmetrisch zu einer sich in Richtung der X-Achse und/oder Y-Achse erstreckenden Symmetrieachse ausgeführt ist.

Weiterhin wurde vorstehend davon ausgegangen, daß der Kühler 1 in dem oberen Bereich, d.h. in geringerem Abstand von der oberen Abschlußlage von den ersten Lagen 7 und im unteren Bereich, d.h. in der Nähe der Ebene E ausschließlich von den Lagen 8 gebildet ist. Grundsätzlich besteht natürlich auch die Möglichkeit, den Kühler 1 so auszubilden, daß mit zunehmenden Abstand von der oberen Abschlußlage 5 zwischen erste Lagen 7 eine zunehmende Anzahl zweiter Lagen 8 eingefügt wird, d.h. sich beispielsweise in der Mitte zwischen den Abschlußlagen 5 und 7 erste und zweite Lagen abwechseln, wobei sich der Anteil an zweiten Lagen 8 mit zunehmenden Abstand von der oberen Abschlußlage 5 erhöht.

Die einzelnen Lagen 7 und 8 sind weiterhin so strukturiert, daß sich im Inneren des Kühlers 8, insbesondere auch in der Kühlerstruktur 12 durchgehende Pfosten 13 gebildet sind, und zwar durch geschlossene Bereiche oder Inseln der einzelnen Lagen 7 und 8, die (geschlossenen Bereiche) miteinander deckungsgleich liegen und miteinander zu diesen sich in Richtung der X-Achse erstreckenden und bis in die äußeren Lagen 5 und 6 reichenden Pfosten verbunden sind. Diese durchgehenden Pfosten 13, die von dem Kühlmedium in allen drei Raumachsen umströmt werden, bewirken u.a. kurze Kühlwege mit geringem Wärmewiderstand zwischen der Oberseite des Kühlers 1 und den unteren Strukturen. Weiterhin dienen diese Pfosten 13 aber auch dazu, um den Druck des Kühlmediums und die hieraus resultierenden Kräfte aufzunehmen.

Wie in der Figur 1 weiterhin angedeutet ist, mündet der Einlaß 3 in eine durch entsprechende Strukturierung der Metall-Lagen gebildete Einlaß-Verteilerkammer 10. Der Auslaß 4 steht mit einer ebenfalls durch die entsprechende Strukturierung der Metall-Lagen gebildeten Auslaß-Sammelkammer 11 in Verbindung. Zwischen diesen Kammern 10 und 11 ist im Inneren des Kühlers 1 durch die Strukturierung der einzelnen Metall-Lagen die Kühlerstruktur bzw. Mikrostruktur 12 gebildet.

Zwischen dem Einlaß 3 und der zugehörigen Kammer 10 und dem Auslaß 4 und der zugehörigen Kammer 11 können durch die Strukturierung der Metall-Lagen 7 und 8 auch noch Verteilerstrukturen 12' gebildet sein, die ebenfalls die sich verzweigenden Strömungswege und die Pfosten 13 aufweisen.

Wie mit dem Pfeil A angedeutet ist, wird das Kühlmedlum im Kühler 1 über dem Einlaß 3 bzw. über die dortige Kammer 10 mit einem Überdruck zugeführt. Entsprechend dem Pfeil B verläßt das Kühlmedium den Kühler nach dem Durchströmen der Mikrostruktur 12 und im Sammeln in der Auslaßkammer 11 am Auslaß 4.

Nachstehend wird die Erfindung nun an verschiedenen Beispielen von strukturierten ersten und zweiten Metall-Lagen beschrieben, die in den nachfolgenden Figuren zur Unterscheidung der verschiedenen Ausführungen jeweils mit dem weiteren Index a - d bezeichnet sind.

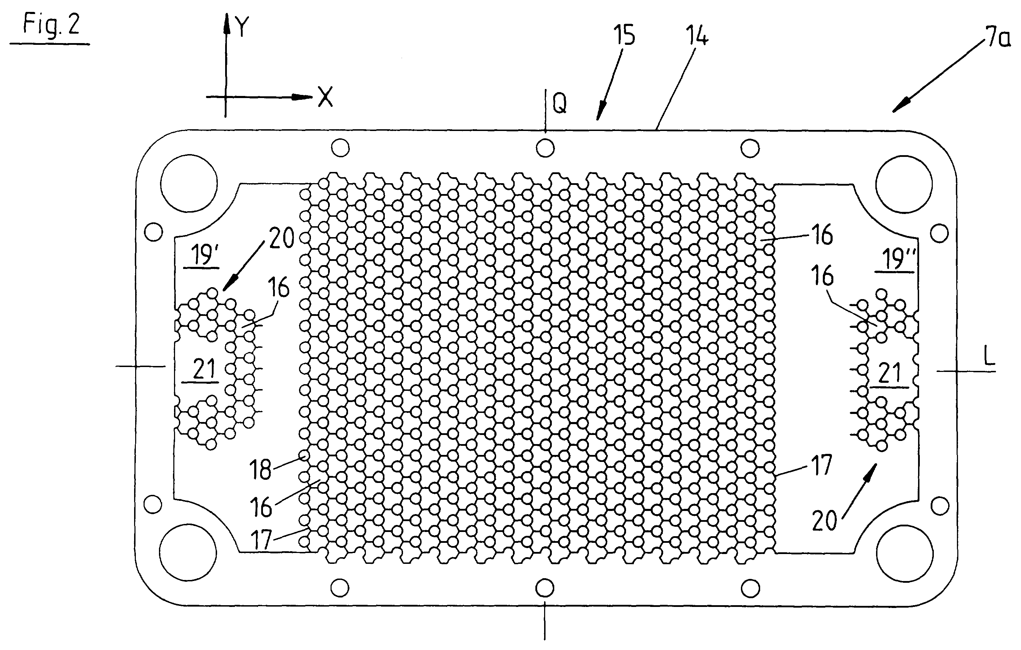

Die Figur 2 zeigt in Draufsicht eine erste Metall-Lage 7a, die von einem dünnen Metallblech, beispielsweise Kupferblech (Kupferfolie) mit einem rechteckförmigen Zuschnitt gebildet ist. In der Figur 2 sind die sich in Richtung der X-Achse erstreckende Mittellängsachse L der Metall-Lage 7a sowie auch die X-Achse und die Y-Achse angegeben.

Die Metall-Lage 7a ist innerhalb eines geschiossenen Randbereiches 14 in dem mittleren Bereich, der in der Figur 2 allgemein mit 15 bezeichnet ist, siebartig mit einer Vielzahl von Durchbrechungen oder Öffnungen 16 versehen, die jeweils sechseckförmig ausgeführt sind und ähnlich einer wabenartigen Struktur aneinander anschließen. Diese Öffnungen 16 sind jeweils von ineinander netzartig übergehenden Stegen 17 gebildet, die jede Öffnung 16 in Form einer Sechseck-Ringstruktur umschließen. An den beiden in Richtung der Y-Achse verlaufenden Rändern des Bereiches 15 sind diese Ringstrukturen nur jeweils unvollständig ausgeführt.

An drei Ecken jeder Sechseck-Ringstruktur jeder Öffnung 16 bilden die Stege 17 Inseln 18 mit vergrößerter Fläche. Bei der dargestellten Ausführungsform sind diese Inseln 18 kreisförmig ausgeführt. Die Inseln 18 können auch eine andere Form aufweisen. Die Inseln 18 sind so verteilt, daß an jeder Öffnung 16 in Richtung der X-Achse eine Ecke mit Insel auf eine Ecke ohne eine solche Insel folgt und außerdem die Mittelpunkte der Inseln 18 die gedachten Eckpunkte eines gleichseitigen Dreiecks bilden, wobei eine Winkelhalbierende zwischen zwei aneinander anschließenden Dreieckseiten in der X-Achse liegt. Weiterhin ist die Strukturierung so gewählt, daß zwei Stege 17 jeder Öffnung 16 in Richtung der X-Achse liegen und in Richtung der X-Achse jeweils auf eine Insel 18 eine Öffnung 16, ein Eckpunkt der Ringstruktur ohne Insel, ein sich in Richtung der X-Achse erstreckender Steg 17 und dann eine neue Insel 18 usw. folgen.

Weiterhin ist die Strukturierung der Metall-Lage 7a nicht völlig symmetrisch zu der sich in Richtung der Y-Achse erstreckenden Mittel-Querachse Q, sondern die Öffnungen 16 sind so gegenüber dieser Querachse Q versetzt, daß letztere nicht die sich in Richtung der X-Achse erstreckenden Stege 17, sondern die Inseln 18 schneidet.

Wie die Figur 2 zeigt, ist die Metall-Lage 7a an den beiden in Richtung der X-Achse voneinander beabstandeten Enden beidseitig vom Bereich 15 so strukturiert, daß dort jeweils eine größere Öffnung 19' bzw. 19'' gebildet ist, in die sich von dem jeweiligen, sich in Richtung der X-Achse erstreckenden Teil des Randes 14 ein entsprechend dem Bereich 15 strukturierter Teilbereich 20 hinein erstreckt, in dem eine weitere größere Öffnung 21 gebildet ist. Insbesondere im Hinblick auf die Öffnungen 19', 19'' und 21 ist die Metall-Lage 7a symmetrisch sowohl zur Mittellängsachse L als auch zur Querachse Q ausgeführt. Bei zu dem Kühler 1 miteinander verbundenen Metall-Lagen 7a bilden die Öffnungen 19'und 19'' die Kammern 10 bzw. 11. Die sich deckenden Öffnungen 21 bildenden Einlaß 3 bzw. Auslaß 4, die dann über die von den Bereichen 20 gebildeten Verteilerstrukturen 12' mit der jeweiligen Kammer 10 bzw. 11 in Verbindung steht. Die Verteilerstrukturen 12' haben zum einen den Vorteil, daß dann auch dort die oben beschriebenen durchgehenden Pfosten 13 vorhanden sind. Weiterhin bewirken die Verteilerstrukturen insbesondere auch eine Verteilung des Kühlmediums beim Austritt in die Kammer 10 bzw. bei Austritt aus der Kammer 11 in den Auslaß 4.

Durch die Verteilerstrukturen und Pfosten 13 ist es weiterhin auch möglich, die Kammern 10 und 11 zur optimalen Verteilung des Kühlmedium insbesondere in der X-Y-Ebene mit großem Querschnitt auszuführen.

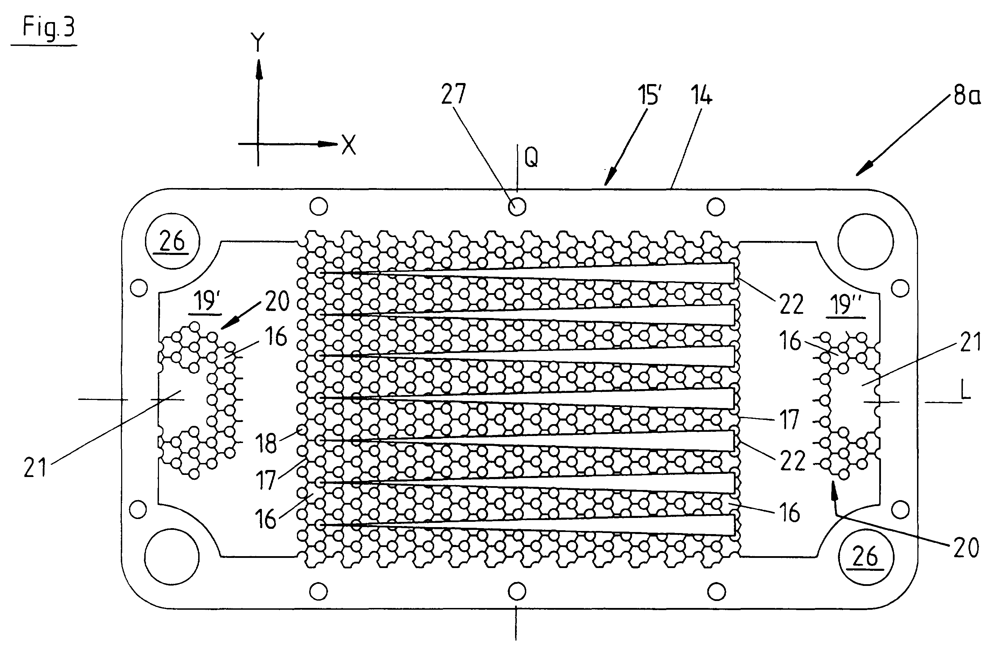

Die Figur 3 zeigt die zweite strukturierte Metall-Lage 8b, die für die Verwendung mit der Metall-Lage 7a geeignet ist. Die Metall-Lage 8 unterscheidet sich von der Metall-Lage 7a im wesentlichen nur dadurch, daß in dem strukturierten Bereich 15' der dortigen Struktur eine zweite Struktur überlagert ist, und zwar in der Form, daß das Verhältnis zwischen der offenen und geschlossenen Fläche in Richtung der X-Achse von der Öffnung 19' zur Öffnung 19'' abnimmt. Hierfür ist der Bereich 15' derart strukturiert, daß mehrere, sich in Richtung der X-Achse erstreckende und sich zur Öffnung 19'' jeweils keilartig verbreiternde Materialstege 22 vorgesehen sind, durch die jeweils ein Teil der Öffnungen 16 des strukturierten Bereichs 15' ausgehend von der Öffnung 19' zur Öffnung 19'' hin zunehmend verschlossen wird. Diese Materialstege 22 sind symmetrisch zu ihrer sich in Richtung der X-Achse erstreckenden Längsachse ausgebildet und besitzen an dem der Öffnung 19'' benachbarten Rand des strukturierten Bereichs 15' eine Breite, die den Mittelabstand zweier in Richtung der Y-Achse aufeinander folgender Inseln 18 entspricht. Auch der Abstand zweier Stege 22 ist an diesem Rand gleich den Achsabstand zweier Inseln. Jeder Steg 22 liegt mit seiner Längsachse parallel zu den sich in Richtung der X-Achse erstreckenden Stegen 17 und achsgleich mit einem Teil dieser Stege.

Bei der in der Figur 3 wiedergegebenen Ausführungsform entspricht die Anordnung der die Öffnungen 16 umschließenden Ringstrukturen, d.h. der Stege 17 und Inseln 18 im strukturierten Bereich 15' in Bezug auf die Längsachse L und Querachse Q der Anordnung, wie sie vorstehend für den strukturierten Bereich 15 der Metall-Lage 7a beschrieben wurde.

Durch die Stege 22 ergibt sich in den von den Metall-Lagen 8a gebildeten Bereichen der Kühlerstruktur 12 ein sich in Richtung der X-Achse reduzierender Strömungsquerschnitt oder ein sich in Richtung der X-Achse erhöhender spezifischer Strömungswiderstand, so daß das Strömungsmittel entsprechend den Linien 9 der Figur 1 zunehmend an der von der oberen Abschlußlage 5 gebildeten Oberseite oder Kühlerfläche konzentriert und dadurch die Kühlwirkung erhöht wird.

Die Metall-Lagen 7a bzw. 8a sind auch jeweils zur Längsachse L symmetrisch ausgeführt. Dies bedeutet, daß für die Herstellung des Kühlers 1 zusätzlich zu Metall-Lagen 7a bzw. 8a der in der Figuren 2 bzw. 3 dargestellten Art auch modifizierte Metall-Lagen 7a bzw. 8a erforderlich sind, die hinsichtlich der Strukturierung den Figuren 2 bzw. 3 entsprechen, bei denen aber die mittlere Struktur 15 bzw. 15' um die Länge eines Steges 17 in Richtung der X-Achse versetzt ist. Im Kühler 1 ist dann jeder Metallage 7a bzw. 8a eine solche modifizierte Metall-Lage benachbart.

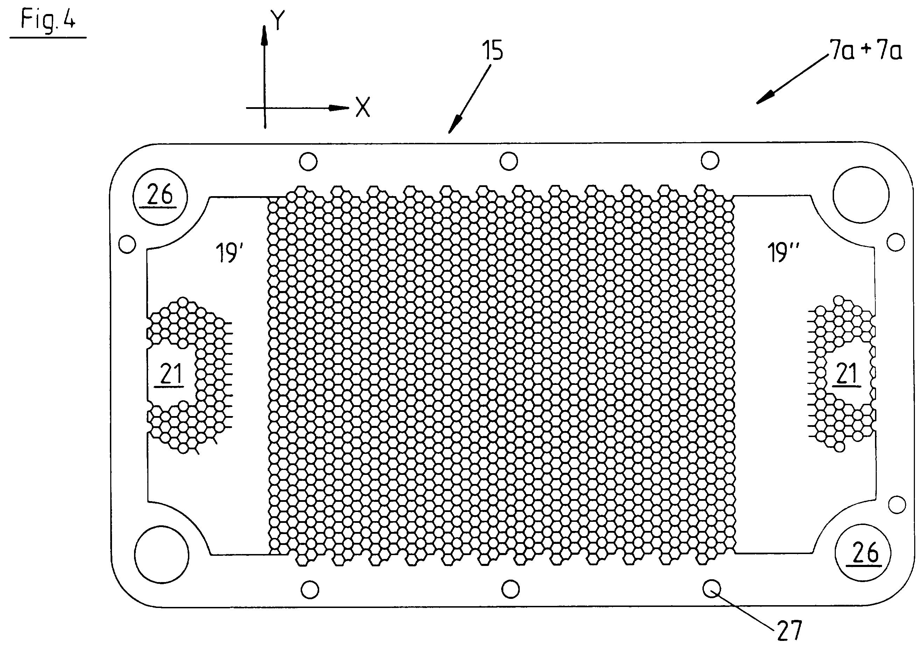

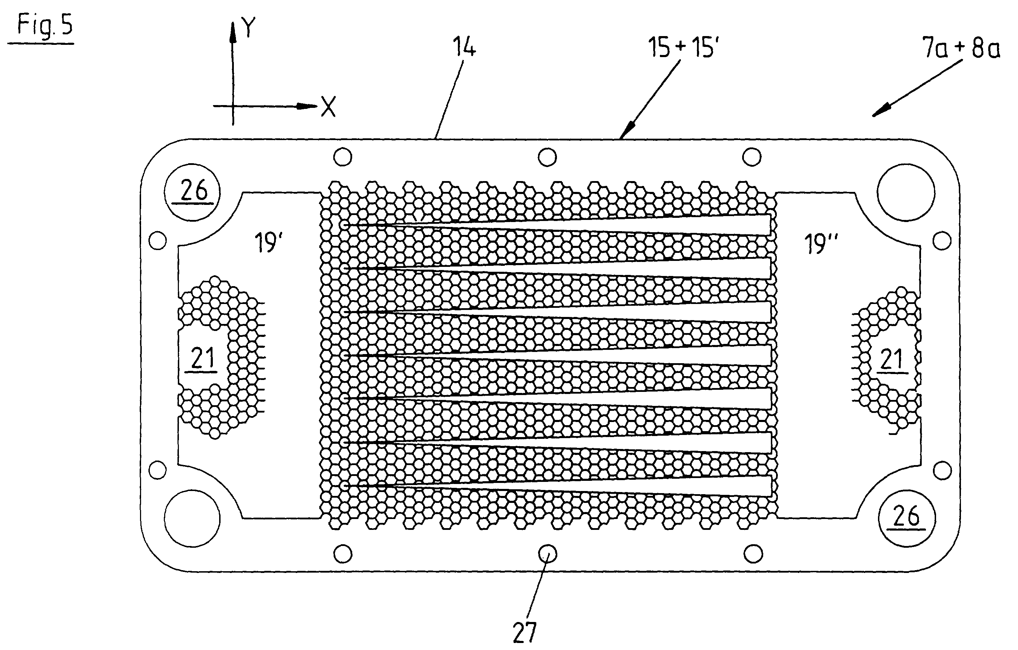

Die Figur 4 zeigt die Struktur, die im Kühler 1 von einander jeweils benachbarten nicht-modifizierten und modifizierten Metall-Lagen 7a gebildet ist. Die Figur 5 zeigt die Struktur die im Kühler 1 von zwei aufeinander folgenden Metall-Lagen 7a und 8a gebildet ist.

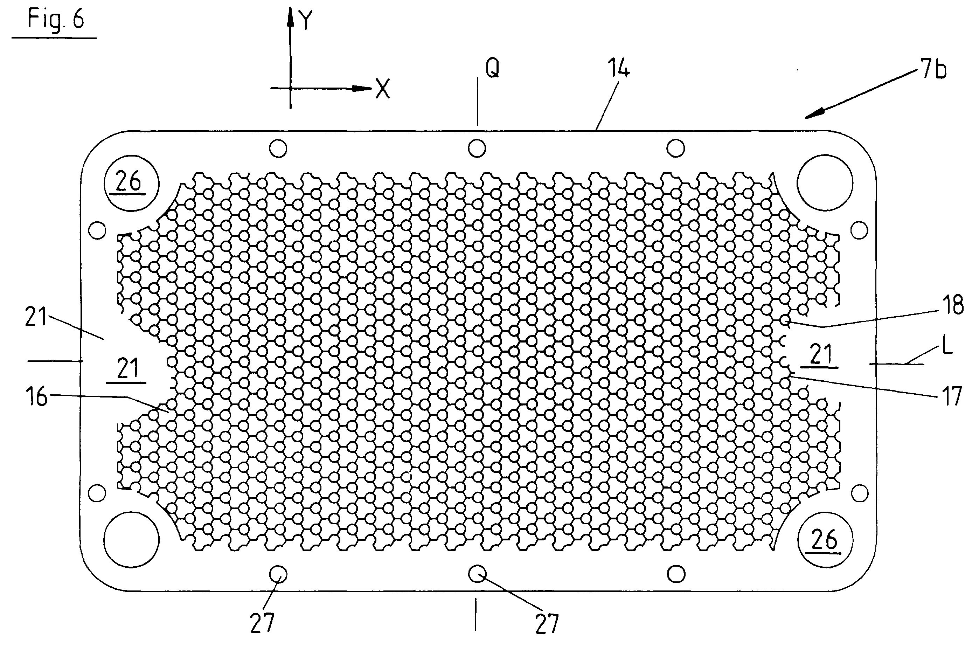

Die Figur 6 zeigt als weitere mögliche Ausführungsform eine Metall-Lage 7b, die sich von der Metall-Lage 7a im wesentlichen nur dadurch unterscheidet, daß sich der die Öffnungen 16 aufweisende strukturierte Bereich sich im wesentlichen auf die gesamte, vom geschlossenen Randbereich 14 umschlossene Fläche erstreckt, d.h. die Öffnungen 19' und 19'' nicht vorgesehen sind, sondern lediglich die Öffnungen 21.

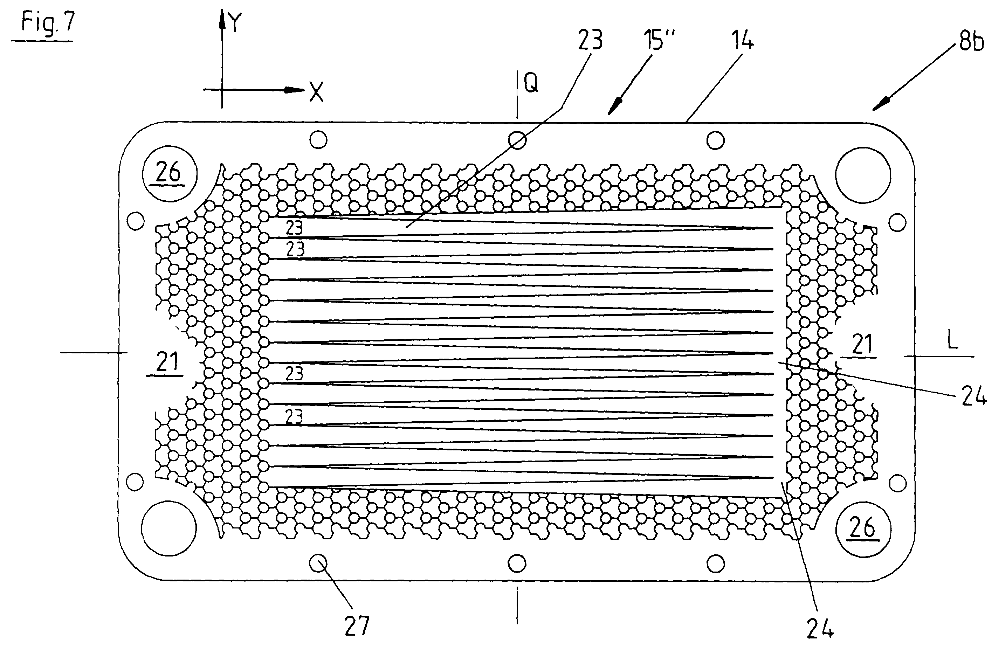

Die Figur 7 zeigt eine für die Metall-Lage 7b passende Metall-Lage 8b, die sich von der Metall-Lage 7b im wesentlichen dadurch unterschiedet, daß im mittleren Bereich, d.h. zwischen den beiden Öffnungen 21 ein strukturierter Bereich 15'' vorgesehen ist, der mehrere sich in Richtung der X-Achse erstreckende, sich keilförmig verengende schlitzförmige Öffnungen 23 aufweist, die bei der Ausführungsform der Figur 7 an ihrem einen Ende jeweils durch Stege 17 der dortigen Ringstrukturen und an ihrem anderen verjüngten Ende durch einen sich in Richtung der Y-Achse erstreckenden Materialsteg 24 begrenzt sind.

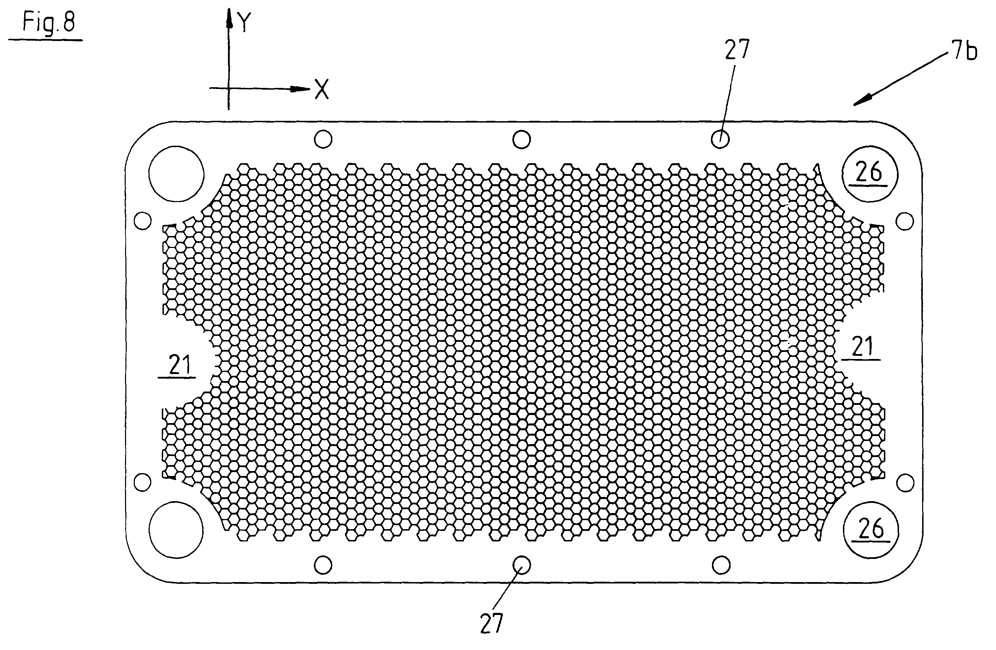

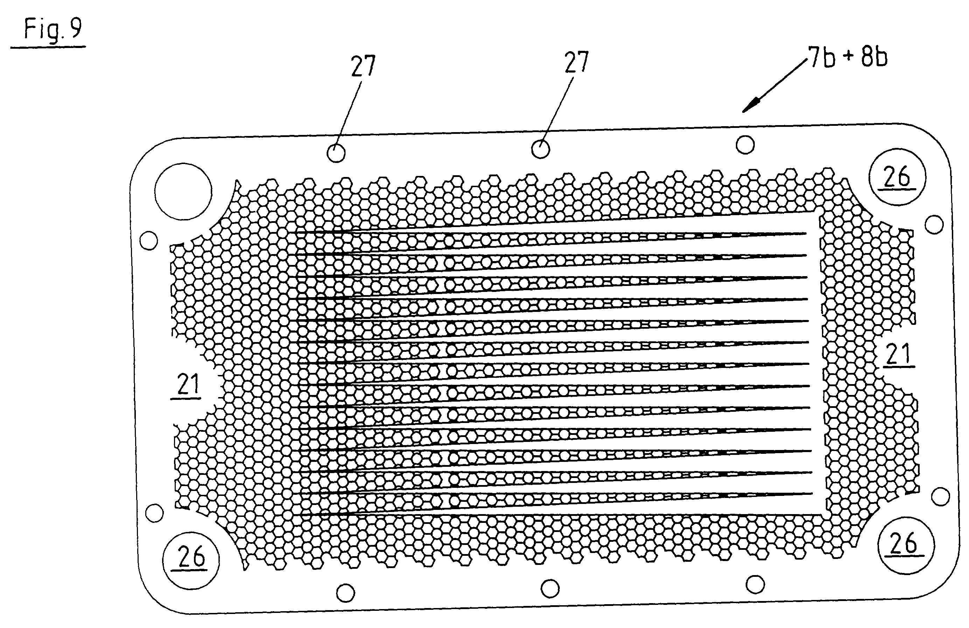

Die Figuren 8 und 9 zeigen die Struktur, die von zwei übereinander liegenden bzw. um Kühler 1 aneinander anschließenden nicht-modifizierten und modifizierten Metall-Lagen 7b (Figur 8) bzw. von zwei aneinander anschließenden Metall-Lagen 7b und 8b (Figur 9) gebildet sind.

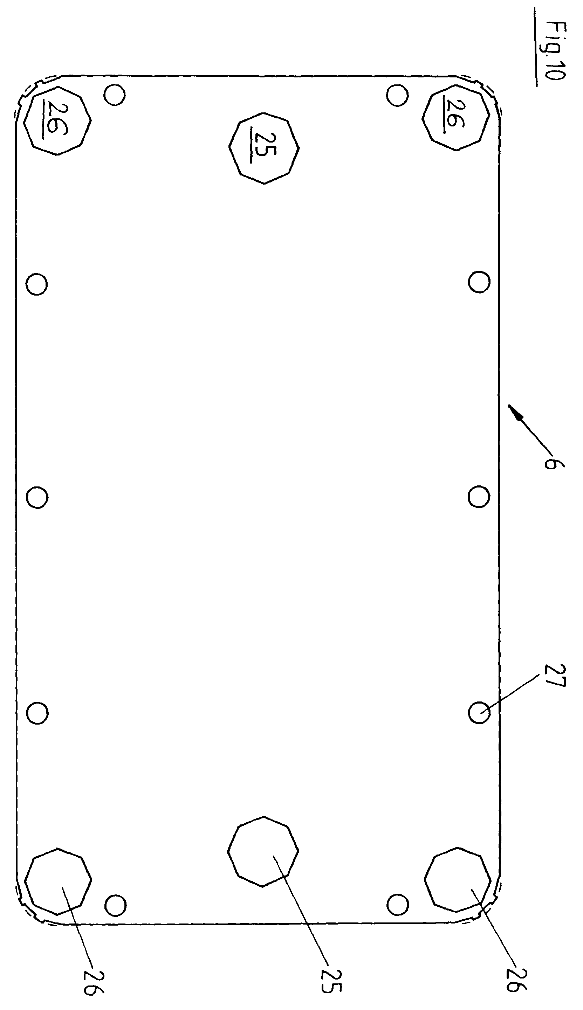

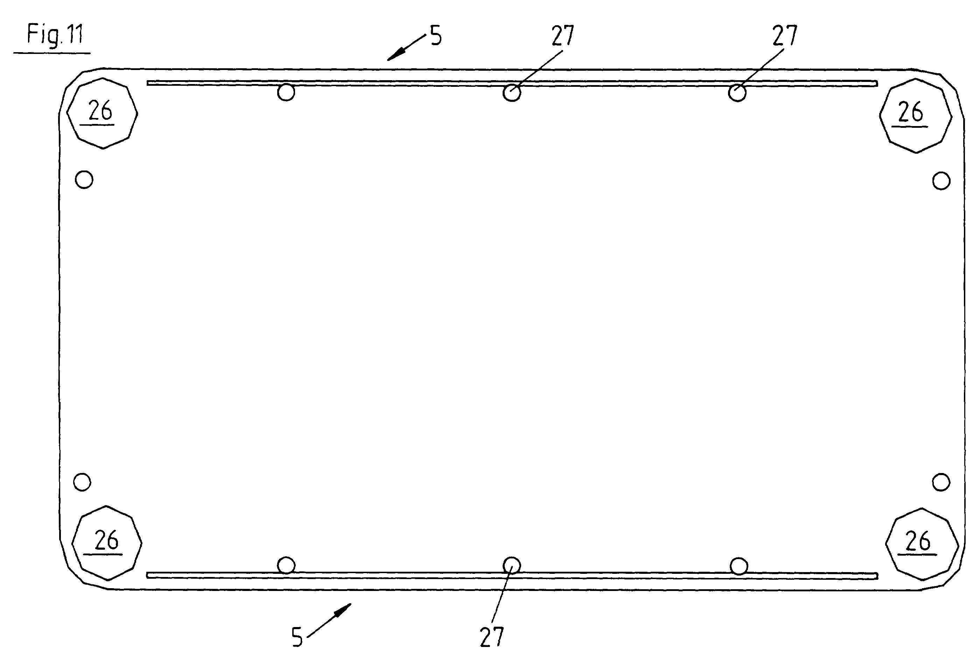

Die Figuren 10 und 11 zeigen nochmals in Einzeldarstellung und in Draufsicht die untere Abschlußlage 6 (Figur 10) bzw. die obere Abschlußlage 5 (Figur 11). Beide Metall-Lagen sind von einem rechteckförmigen Zuschnitt des Metallbleches (z.B. Kupferfolie) gebildet. In der unteren Abschlußlage 6 sind zwei Öffnungen 25 vorgesehen, und zwar für die beiden Anschlüsse 3 und 4.

Wie die Figuren 2 - 11 weiterhin zeigen, sind sämtliche Metall-Lagen an ihren Ecken mit Öffnungen 26 und an den Umfangsseiten mit Öffnungen 27 versehen. Diese Öffnungen 26 und 27 bilden nach dem Aufeinanderlegen der verschiedenen Metall-Lagen zu dem Kühler 1 durchgehende Zentner- und Befestigungsbohrungen, die beispielsweise bei der Herstellung des Kühlers 1, d.h. bei Verbinden der einzelnen Metall-Lagen 5 - 7 zu dem Kühler zum Zentrieren und/oder vorläufigen Zusammenhalten der Lagen verwendet werden. Die von den Öffnungen 26 gebildeten Bohrungen dienen bei Verwendung des Kühler 1 auch zu dessen Befestigung.

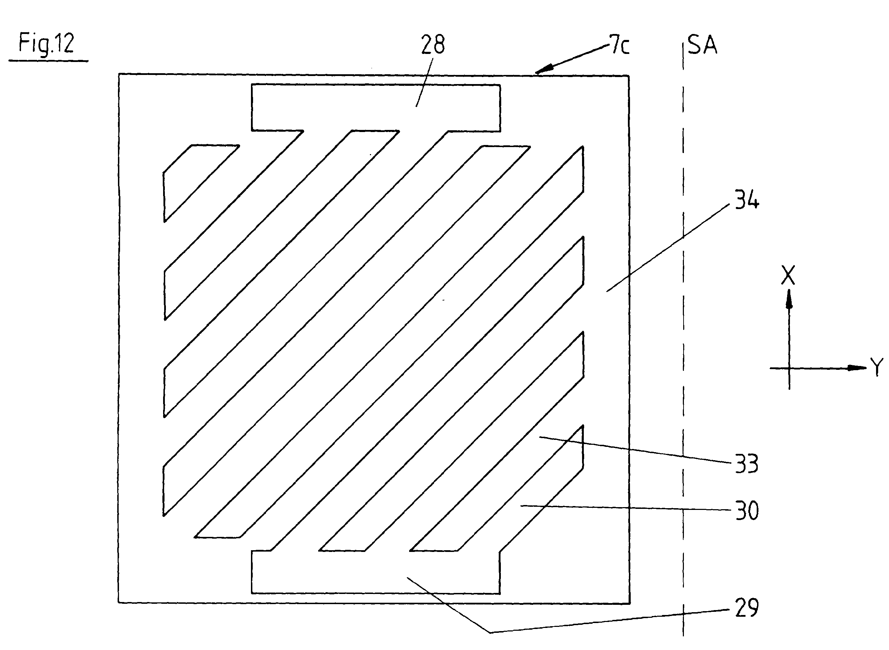

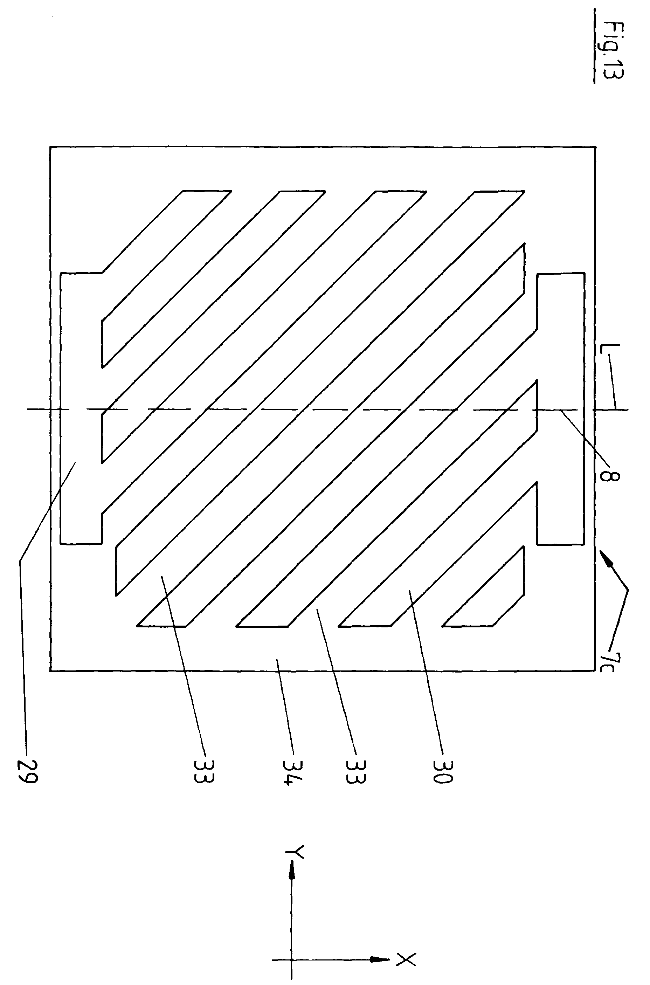

Die Figuren 12 und 13 zeigen als weitere Ausführungsform eine erste Lage 7c in nicht modifizierter Form (Figur 12) sowie in modifizierter Form (Figur 13), die im Kühler 1 unmittelbar aneinander anschließend verwendet sind und im Prinzip die gleiche Strukturierung aufweisen, lediglich in der Form, daß die modifizierte Metall-Lage 7c der Figur 13 spiegelbildlich zu der nicht modifizierten Lage 7c der Figur 12 ausgeführt ist, und zwar gespiegelt an einer in der Figur 12 mit SA bezeichneten und sich in der X-Achse erstreckenden Spiegelachse.

Die Metall-Lage 7c besitzt einen quadratischen Zuschnitt und ist im Bereich ihrer beiden, in Richtung der Y-Achse verlaufenden Seiten jeweils mit einer rechteckförmigen Öffnung 28 bzw. 29 versehen, die mit ihrer Längserstreckung in der Y-Achse liegt. Die Öffnungen 28 und 29 sind in der X-Achse voneinander beabstandet. Weiterhin weist die Metall-Lage 7c eine Vielzahl von schlitzförmigen Öffnungen 30 auf, die mit ihrer Längserstreckung die in Richtung der X-Achse verlaufende Mittellängsachse L unter einem Winkel schneiden, der kleiner ist als 90°, wobei bei der dargestellten Ausführungsform dieser Winkel 45° beträgt.

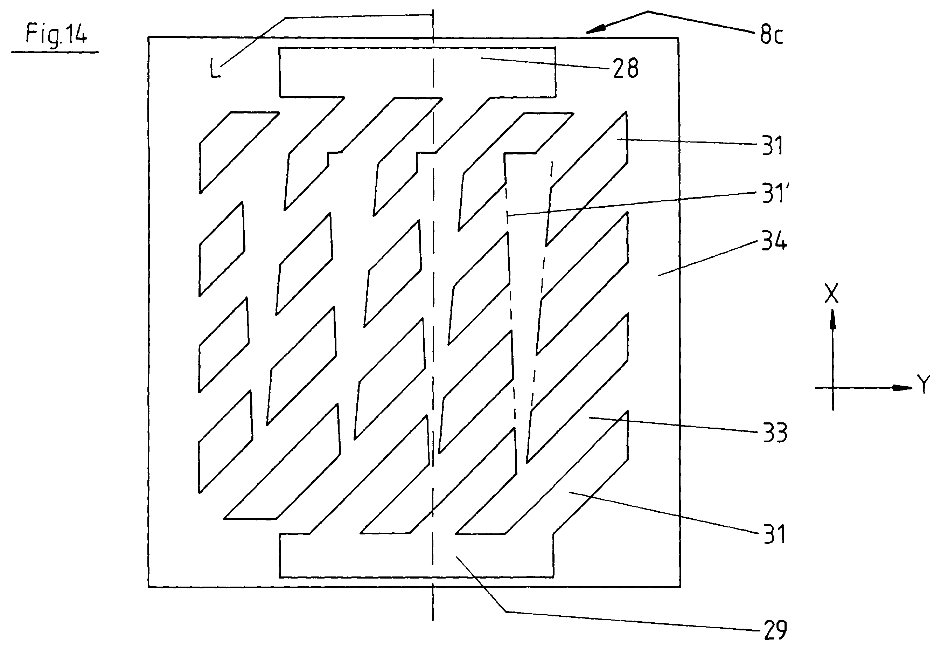

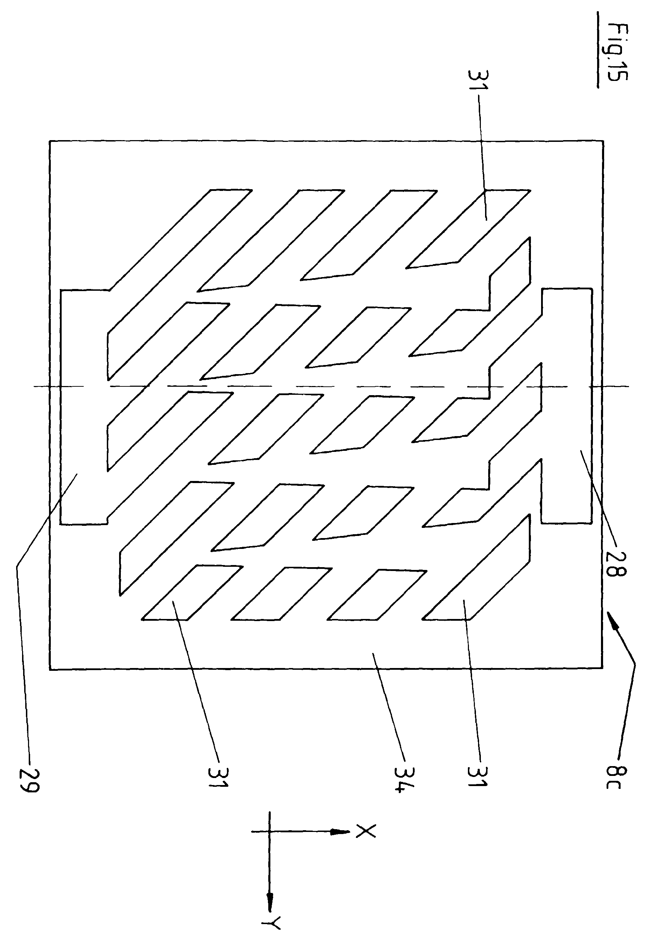

Die Figuren 14 und 15 zeigen die zweite Metall-Lage 8c, die zusammen mit der ersten Metall-Lage 7c für die Herstellung des Kühlers 1 verwendet werden kann. In der Figur 14 ist die Metall-Lage 8c wiederum in der nicht-modifizierten Form und in der Figur 15 in der modifizierten Form wiedergegeben. Letztere ist hinsichtlich ihrer Strukturierung dadurch erhalten, daß die nicht modifizierte Metall-Lage 8c an der in der X-Achse liegenden Spiegelachse SA gespiegelt wurde.

Die Strukturierung der Metall-Lage 8c läßt sich dahingehend beschreiben, daß zusätzlich zu den beiden Öffnungen 28 und 29 schlitzförmige Öffnungen 31 vorgesehen sind, die mit ihrer Längserstreckung mit der Längsachse L oder X-Achse einen spitzen Winkel einschließen, beispielsweise einen Winkel von 45°. Die schlitzförmigen Öffnungen 31 sind zumindest teilweise zwischen ihren jeweiligen Enden unterbrochen und/oder in ihrer Breite eingeschnürt. Diese Unterbrechungen oder Einschnürungen sind dadurch gebildet, daß bei der Strukturierung keilförmige Materialstege oder -Bereiche belassen sind, von denen einer in der Figur 14 mit der unterbrochnen Linie 31' angedeutet ist. Diese keilförmigen Materialbereiche liegen mit ihrer Längserstreckung in der X-Achse und verbreitern sich spiegelbildlich zu ihrer Längsachse zu der mit der Öffnung 28 versehenen Seite der Metall-Lage 8c hin.

Durch die keilförmigen, belassenen Materialbereiche 31' ergeben sich somit an den schlitzförmigen Öffnungen 31 diese unterbrechende und/oder in der Breite einschnürende Material-Stege, deren Breite in Richtung der X-Achse von der Öffnung 29 zur Öffnung 28 hin zunimmt, wodurch auch der Strömungswiderstand in dem von den Metall-Lagen 8c gebildeten Teil des Kühlers in Flußrichtung von der Öffnung 29 zur Öffnung 28 hin zunimmt. Die belassenen, keilförmigen Materialbereiche 31' ergeben weiterhin zusätzliche Verbindungsstege in den strukturierten Metall-Lagen 8c und erhöhen damit deren mechanische Festigkeit. Weiterhin sind die belassenen Materialbereiche 31' z.B. symmetrisch zu einer sich in der X-Achse erstreckenden Mittelachse ausgebildet und angeordnet sind, so daß bei abwechselnd aufeinandergelegten nicht-modifizierten und modifizierten Metall-Lagen 8c die keilförmigen belassenen Materialbereiche 31' dieser miteinander verbundenen Metall-Lagen 8c durchgehende, keilförmige Pfosten bilden.

Zur Herstellung des Kühlers 1 werden die Metall-Lagen 7c und auch die Metall-Lagen 8c stapelartig übereinandergelegt, und zwar derart, daß jeweils eine nicht modifizierte Metall-Lage 7c bzw. 8c einer modifizierten Metall-Lage 7c bzw. 8c benachbart ist und sämtliche Öffnungen 28, aber auch sämtliche Öffnungen 29 deckungsgleich übereinander liegen und die Öffnungen 29 die Kammer 10 und die Öffnungen 28 die Kammer 11 bilden. Durch die Verwendung von modifizierten und nicht modifizierten Metall-Lagen 7c und 8c kreuzen sich die schlitzförmigen Öffnungen 30 bzw. 31, so daß an den Kreuzungspunkten in Richtung der Z-Achse verlaufende Durchlässe gebildet sind. Durch die vorstehend beschriebene Strukturierung der Metall-Lage 8c wird wiederum eine Reduzierung des Strömungsquerschnittes und damit eine Erhöhung des spezifischen Strömungswiderstandes zwischen den Kammern 10 und 11 in dem die Metall-Lagen 8c enthaltenden Bereich der Kühlerstruktur und damit eine verbesserte Querverteilung des Kühlmediums erreicht. Dieses wird bei der Durchströmung der Kühlerstruktur zwischen den Kammern 10 und 11 zunehmend an die die Oberseite des Kühlers bildende äußere Abschlußlage 5 gedrängt, wobei gleichzeitig aber auch im unteren Bereich des Kühlers 1 eine gewisse Strömung des Kühlmediums erhalten bleibt.

Es versteht sich, daß die Öffnungen 31 zur Erhöhung des spezifischen Strömungswiderstandes auch anders als in den Figuren 14 und 15 dargestellt ist, ausgeführt sind können. So ist es beispielsweise möglich, daß zumindest einige Öffnungen 31 eine sich beispielsweise keilförmig oder treppen- oder stufenförmig reduzierende Öffnungsbreite aufweisen. Es versteht sich weiterhin, daß anstelle der Metall-Lagen 8c auch andere Metall-Lagen verwendet werden, die so strukturiert sind, daß sich in Strömungsrichtung eine Zunahme des spezifischen Strömungswiderstandes bzw. Verringerung des effektiven Strömungsquerschnittes ergibt.

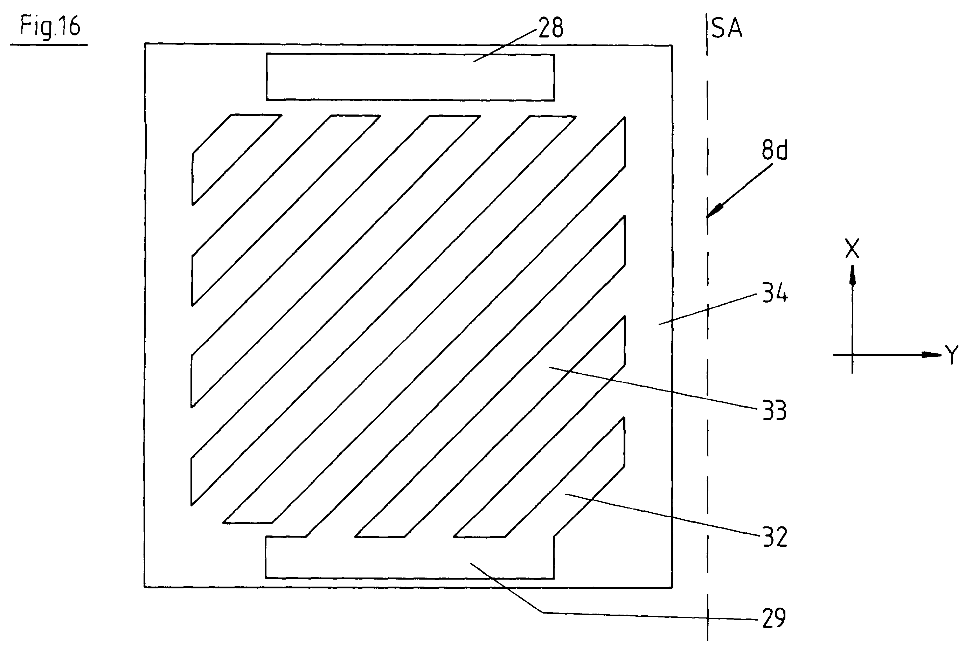

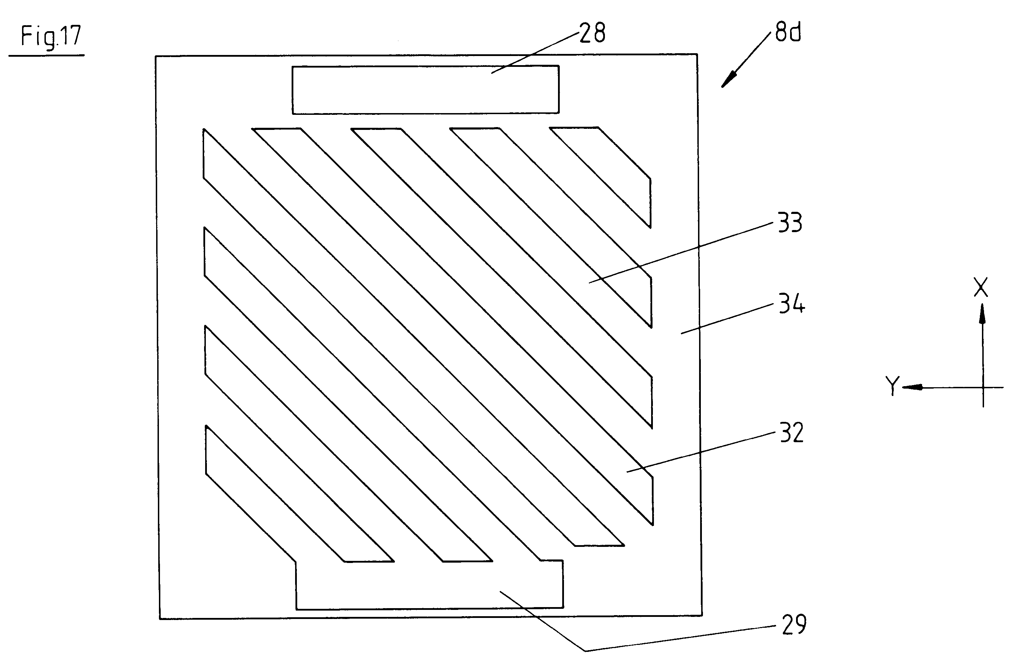

Die Figuren 16 und 17 zeigen in nicht modifizierter Form (Figur 16) und in modifizierter Form (Figur 17) eine Metall-Lage 8d, die anstelle der Metall-Lage 8c oder aber zusammen mit dieser in Verbindung mit der Metall-Lage 7c der Figuren 12 und 13 verwendbar ist.

Die Metall-Lage 8d unterscheidet sich hinsichtlich ihrer Strukturierung von der Metall-Lage 8c im wesentlichen nur dadurch, daß schlitzförmige Öffnungen 32 vorgesehen sind, die bei der dargestellten Ausführungsform den Öffnungen 30 der Metall-Lage 7c entsprechen, allerdings so ausgeführt sind, daß keine der Öffnungen 32 in die Öffnung 28 hineinreicht, so daß in dem von den Metall-Lagen 8d gebildeten Bereich der Kühlerstruktur, in der sich selbstverständlich wiederum modifizierte und nicht modifizerte Metall-Lagen 8d abwechseln, in Strömungsrichtung vor dem von den Öffnungen 28 gebildeten Kanal 11 eine Barriere für das Kühlmedium gebildet ist, durch die dieses Kühlmedium an die die Kühlerfläche bildende Oberseite des Kühlers 1 umgelenkt wird.

Bei der Darstellung der Figuren 12 - 17 wurde davon ausgegangen, daß keine der schlitzförmigen Öffnungen 30, 31 oder 32 beidendig in die Öffnungen 28 und 29 münden. Hierdurch ist sichergestellt, daß die zwischen den Öffnungen 30 - 32 gebildeten Materialstege, die in diesen Figuren allgemein mit 33 bezeichnet sind, mit den übrigen, geschlossenen Bereichen der jeweiligen Metall-Lage, insbesondere auch mit dem rundherum geschlossenen Randbereich 34 mechanisch verbunden sind. Allerdings können bei entsprechender Strukturierung, beispielsweise bei Verwendung von Brücken usw. auch zumindest einige schlitzförmige Öffnungen in beide Öffnungen 28 und 29 einmünden.

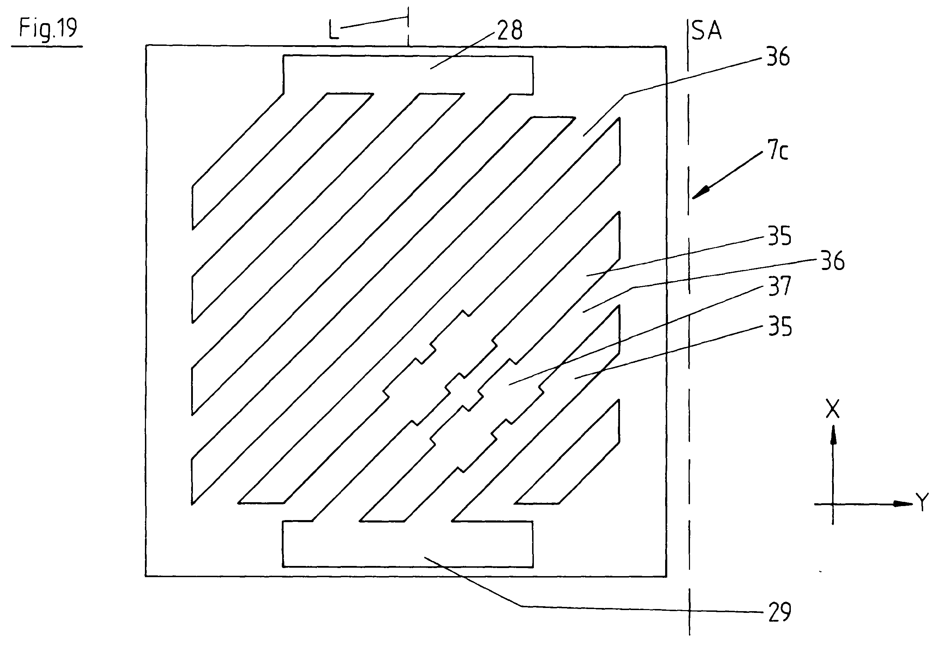

Bei der Beschreibung der Figur 1 wurde davon ausgegangen, daß der Kühler 1 nur an seiner Oberseite zur Aufnahme von zu kühlenden Komponenten 2 dient. Die Figur 18 zeigt einen Kühler 1a, der sich vom Kühler 1 im wesentlichen dadurch unterscheidet, daß die Ebene E die Mittelebene des Kühlers 1a ist, an beiden Seiten dieser Ebene E zunächst unter Verwendung der zweiten Metall-Lagen 8 hergestellte Bereiche der Kühlerstruktur mit zunehmenden Strömungswiderstand gebildet sind und dann außen liegend Bereiche unter Verwendung der Metall-Lagen 7, so daß eine Steuerung der Querverteilung symmetrisch zur Ebene E erfolgt. Oben und unten ist der Kühler 1a jeweils mit einer äußeren Abschlußlage 5 abgeschlossen. Das Zuführen und Abführen des Kühlmediums erfolgt über einen Anschluß bzw. Einlaß 3a bzw. Auslaß 4a, die an den beiden einander gegenüberliegenden Stirnseiten des Kühlers 1a vorgesehen sind, und zwar bei der dargestellten Ausführungsform mit ihren Achsen in der Ebene E liegend.

Obwohl in der Figur 18 der besseren Übersichtlichkeit wegen wiederum nur die Metall-Lagen 5 und zwischen diesen nur einige der Metall-Lagen 7 und 8 gezeigt sind, besteht der Kühler 1a selbstverständlich ebebfalls ausschließlich aus solchen stapelartig über einander angeordneten und flächig mit einander verbundenen Metall-Lagen, d.h. zwischen den exemplarisch dargestellten Lagen 7 und 8 befinden sich weitere Metall-Lagen 7 bzw. 8.

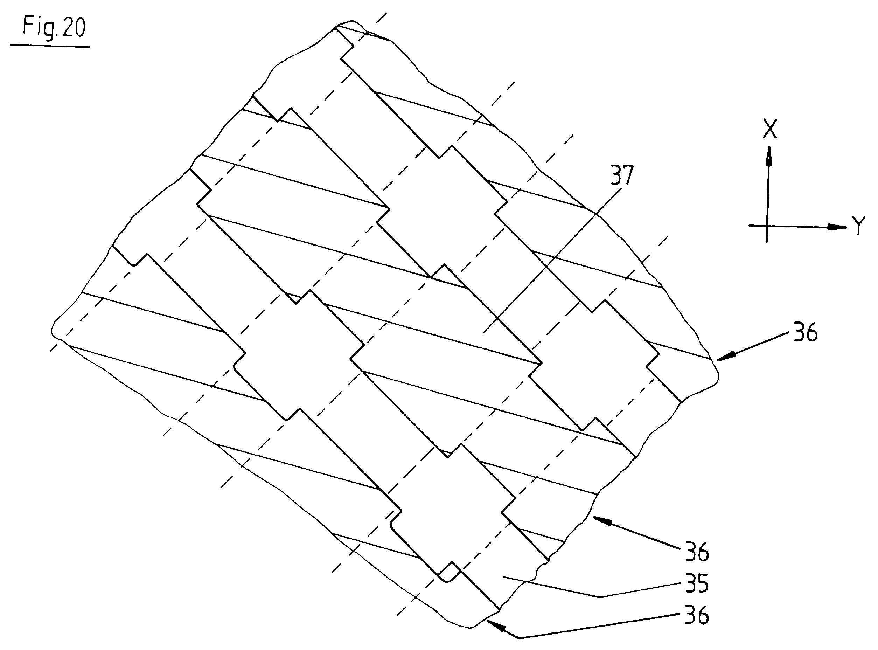

Die Figur 19 zeigt eine Metall-Lage 7e, deren Strukturierung der Strukturierung der Metall-Lage 7c (Figur 12) sehr ähnlich d.h. die Metall-Lage 7e besitzt wiederum an den beiden in der Y-Achse verlaufenden Seiten der quadratischen Metall-Lage 7e die rechteckförmigen Öffnungen 28 und 29 die mit ihrer Längserstreckung in der Y-Achse liegen und in der X-Achse voneinander beabstandet sind. Weiterhin besitzt die Metall-Lage 7e die schlitzförmigen Öffnungen 35, die mit ihrer Längserstreckung einen Winkel kleiner als 90°, beispielsweise einen Winkel von 45° mit der in der X-Achse liegenden Mittel-Längsachse L der Metall-Lage 7e einschließen. Die Metall-Lage 7e weicht hinsichtlich ihrer Strukturierung von der Metall-Lage 7c insofern ab, als die zwischen den Öffnungen 35 gebildeten Materialstege 36 jeweils in einem vorgegebenen Raster bei 37 verbreitert und dementsprechend die Öffnungen 35 in ihrer Breite verringert sind. Bei der dargestellten Ausführungsform sind die Materialstege 36 an den Verbreiterungen 37 jeweils quadratisch ausgeführt. Die Verbreiterungen 37 befinden sich dort, wo bei einem Aufeinanderliegen einer nicht modifizierten Metall-Lage 7e und einer modifizierten Metall-Lage 7e sich die Materialstege 36 kreuzen, so daß an diesen Kreuzungspunkten im Kühler 1b durchgehende Pfosten 13 mit besonders großem Querschnitt gebildet sind (hierzu auch Figur 20).

Bei den in den Figuren 19 und 20 dargestellten quadratischen Verbreiterungen 37 ist die Strukturierung beispielsweise, wie folgt, ausgeführt:

### Breite der Materialstege 36 außerhalb der Verbreiterungen 37:

0,05 bis 0,5 mm, vorzugsweise 0,7 mm

### Seitenlängen der Verbreiterungen 37:

0,1 bis 10 mm, vorzugsweise 1,4 mm

### Achsabstand zweier Materialstege 36:

0,15 bis 15 mm, vorzugsweise 2,1 mm.

Für die Verbreiterungen 37 sind auch andere Formen denkbar, beispielsweise Ellipsen, Kreise, Rauten, Tropfen usw.. Im letzten Fall ist die Formgebung der Verbreiterungen vorzugsweise so gewählt, daß die von diesen Verbreiterungen gebildeten Pfosten einen in Strömungsrichtung abnehmenden Querschnitt aufweisen.

Zu der Metall-Lage 7e der Figur 19 gehört wiederum eine modifizierte Metall-Lage 7e, die durch Spiegelung der nicht modifizierten Metall-Lage 7e der Figur 19 an der dortigen sich in Richtung der X-Achse erstreckenden Spiegelachse SA erhalten ist.

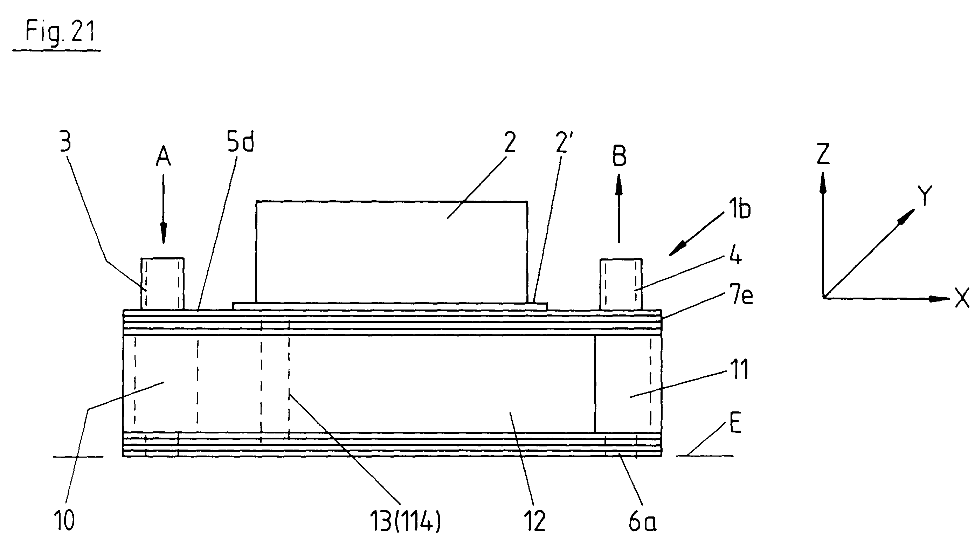

In der Figur 21 ist ein Kühler 1b dargestellt, der als Wärmesenke zum Abführen von Verlustwärme (Verlustleistung) eines elektrischen oder elektronischen Bauelementes oder einer Bauelementegruppe, beispielsweise eines Halbleiterleistungs-Bauelementes oder -Modul dient. Die elektrische oder elektronische Komponente ist in der Figur 21 allgemein mit 2 bezeichnet.

Der Kühler 1b ist mehrlagig ausgeführt, d.h. er besteht aus mehreren Kühler-Lagen bzw. Metall-Lagen, die beispielsweise Kupferlagen sind, die stapelartig übereinander angeordnet und flächig miteinander verbunden sind, und zwar zu dem an den Außenflächen quarderförmig ausgebildeten Kühler 1. Der Figur 21 ist weiterhin mit 3 ein Einlauf für das Kühlmedium, vorzugsweise für ein flüssiges Kühlmedium, beispielsweise Wasser bezeichnet. Mit 4 ist der Auslaß bezeichnet, an dem das Kühlmedium bzw. das wärmetransportierende Medium den Kühler 1b verläßt.

Im Einzelnen bilden die Metall-Lagen eine obere Abschluß-Lage 5 und eine untere Abschluß-Lage 6. Die obere Abschluß-Lage 5 ist durchgehend, d.h. nicht strukturiert ausgebildet. Die untere Abschluß-Lage 6 besitzt Öffnungen für die Anschlüsse 3 und 4.

Zwischen diesen äußeren Metall-Lagen 5 und 6 sind im Inneren des Kühlers die strukturierten Metall-Lagen vorgesehen, die stapelartig aneinander anschließen. Die strukturierten Metall-Lagen sind die vorbeschriebenen Metall-Lagen 7e, wobei wiederum modifizierte und nicht modifizierte Metall-Lagen 7e aneinander anschließen. Die sich deckenden Öffnungen 29 und die sich ebenfalls deckenden Öffnungen 29a der Metall-Lagen 7e bilden dann bei diesem Kühler 1b die Kammern 10 und 11. Sämtliche Metall-Lagen 5, 6 und 7e liegen mit ihren Oberflächenseiten bei der für die Figur 21 gewählte Darstellung in der X - Y - Ebene. In der Z-Ebene folgen die Metall-Lagen im Stapel aufeinander, und zwar in der Weise, daß einer strukturierten Metall-Lage 7e jeweils eine modifizierte Metall-Lage 7e benachbart liegt. Die Metall-Lagen 5, 6 und 7e sind mittels der DCB-Technik miteinander verbunden.

Im Betrieb durchströmt das über den Einlaß 3 zugeführte Kühlmedium den Innenraum des Kühlers 1b durch ein weitverzweigtes, von der Strukturierung der Metall-Lagen 7e gebildetes Kanalsystem. Der Einlaß 3 und Auslaß 4 sind bei der für die Figur 21 gewählten Darstellung in Richtung der X-Achse gegeneinander versetzt.

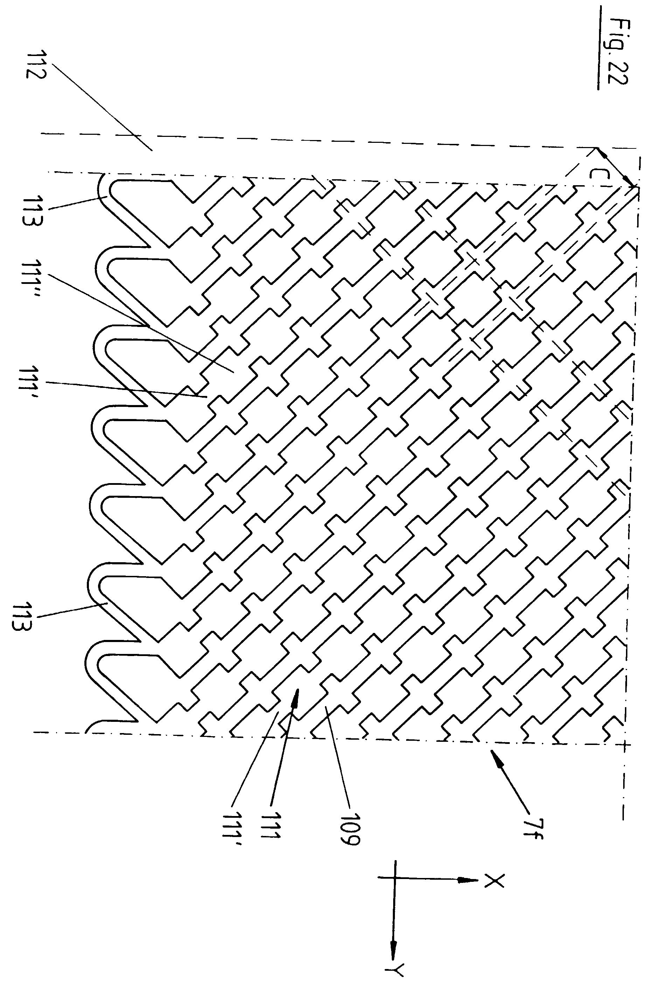

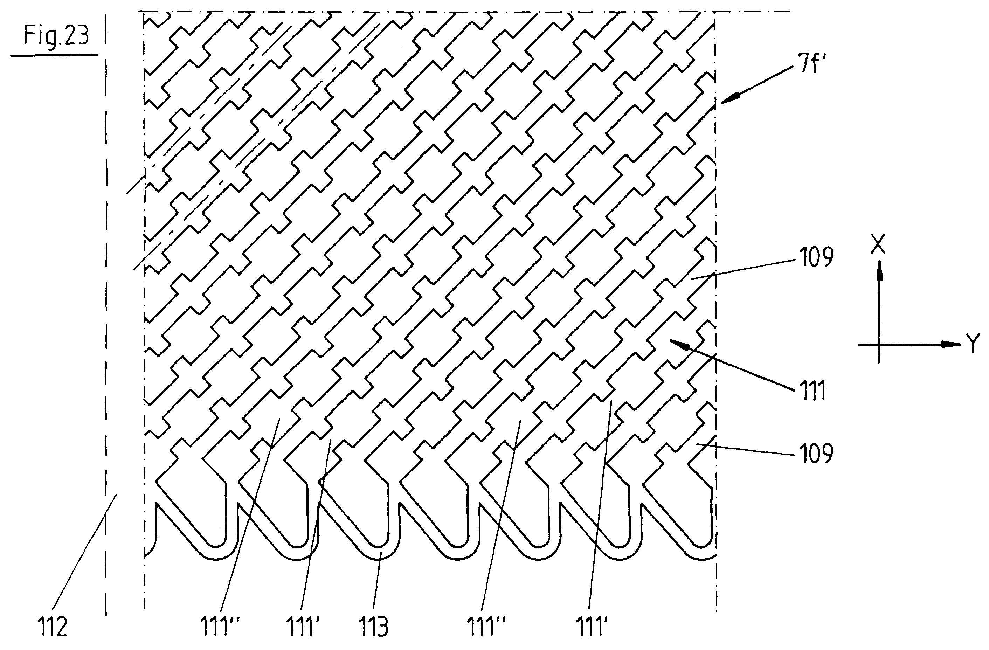

Die Figuren 22 und 23 zeigen als weitere Ausführung strukturiere Metall-Lagen 7f und 7f', von denen die Metalllage 7f' die modifizierte Form der Metall-Lage 7f ist und die anstelle der Metall-Lagen 7e bei dem Kühler 1b verwendet werden können.

Diese Strukturierung der Metall-Lage 7f ist dadurch gebildet, daß in das Metall der Metall-Lage 7f eine Vielzahl von Schlitzen 109 eingebracht ist, die jeweils mit ihrer Längserstreckung der Achse C liegen und einen Winkel von 45° mit der X-Achse einschließen. Sämtliche Schlitze 109 liegen parallel zueinander und benachbarte Schlitze 109 besitzen jeweils den selben Achsabstand c voneinander.

In regelmäßigen Abständen sind die Schlitze 109 mit seitlichen Ausklinkungen 110 versehen, und zwar derart, daß diese Ausklinkungen 110 jeweils paarweise einander gegenüberliegend an den beiden Längsseiten jedes Schlitzes gebildet sind. Die Ausklinkungen 110 jedes Paares von Ausklinkungen liegen auf einer gemeinsamen Achse D, auf der auch Ausklinkungen 110 benachbarter Schlitze 109 vorgesehen sind, d.h. sämtliche Ausklinkungen 110 befinden sich auf den Achsen D, die parallel zueinander verlaufen und den Abstand d voneinander aufweisen. Bei der dargestellten Ausführungsform schneiden sich die Achse C und D jeweils im rechten Winkel. Der Abstand c ist gleich dem Abstand d. Die Breite der Ausklinkungen 110 senkrecht zur jeweiligen Achse D ist gleich der Breite der Schlitze 109.

Die Strukturierung ist weiterhin so, daß zwischen den einzelnen Schlitzen 109 und auch zwischen jeder Ausklinkung 110 eines Schlitzes 109 und der Ausklinkung 110 eines benachbarten Schlitzes Materialstege 111 verbleiben. Um diese Materialstege 111 mechanisch auch im Bereich des Einlasses 3 und des Auslasses 4 miteinander und auch mit einem dem strukturierten Bereich der Metall-Lage 7f umgebenden, einen geschlossenen Rahmen bildenden Randbereich 112 verbunden, und zwar im Bereich des Einlasses 3 und des Auslasses 4 über geschwungene Materialstege 113.

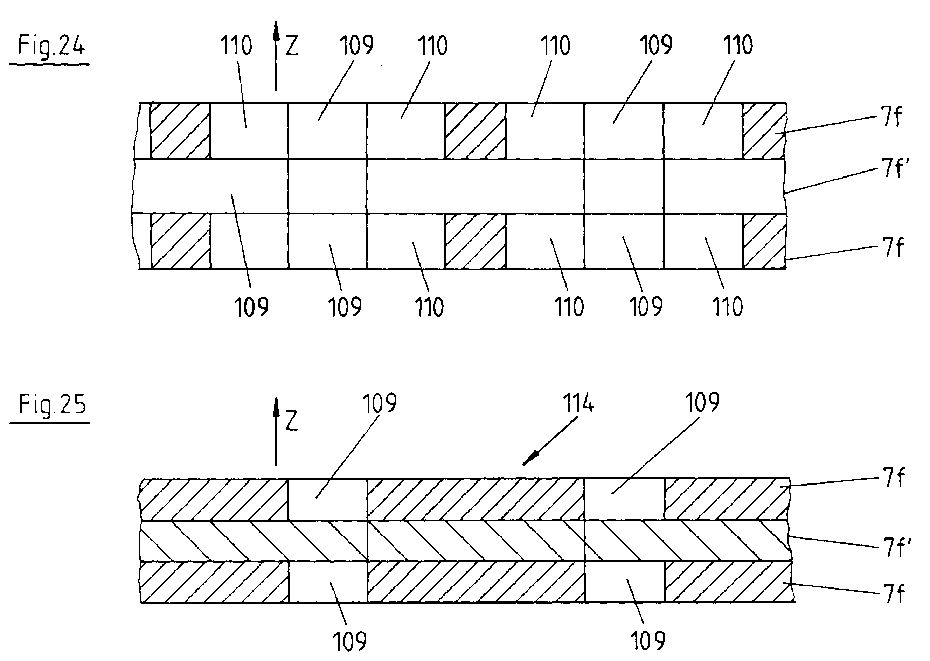

Die Figur 23 zeigt die Strukturierung der modifizierten Metall-Lagen 7f'. Diese entspricht der Strukturierung der Metall-Lage 7f allerdings in modifizierter Form derart, daß die Längsschlitze 109 der Metall-Lage 7f' mit ihrer Längserstreckung in der Achsrichtung D und die Ausklinkungen 110 auf den Achsen C angeordnet sind, und zwar derart, daß bei im Kühler 1b abwechselnd übereinander angeordneten Metall-Lagen 7f und 7f' sich nicht nur die Längsschlitze 109 benachbarter Metall-Lagen unter einem Winkel von 90° schneiden, sondern jeder Längsschlitz 109 einer Metall-Lage einer sich senkrecht zu diesem Längsschlitz erstreckenden Reihe von Ausklinkungen 110 der angrenzenden Metall-Lage unmittelbar benachbart liegt. Hierdurch ergeben sich an den Kreuzungspunkten der Längsschlitze 109 benachbarter Metall-Lagen durch die Ausklinkungen 110 verbreiterte Durchlässe zwischen den sich kreuzenden Längsschlitzen 109 benachbarter Metall-Lagen, wie dies in der Figur 24 deutlich dargestellt ist, und zwar eine Verbreiterung durch jeweils vier an den Kreuzungspunkten vorgesehene Ausklinkungen 110 der beiden Metall-Lagen, wobei jede Ausklinkung 110 einer Metall-Lage eine in den Längsschlitz 109 der benachbarten Metall-Lage mündende Verbreiterung bildet. Durch die zwischen den Ausklinkungen 110 benachbarter Schlitze 109 verbleibenden Bereiche 111' der Materialstege 111 ist eine Änderung der Flußrichtung des wärmetransportierenden Mediums beispielsweise aus der Richtung der Achse C in Richtung der Achse D oder umgekehrt nur dadurch möglich, daß das wärmetransportierende Medium aus den Längsschlitzen 109 beispielsweise der Metall-Lage 7f in die Längsschlitze 109 der Metall-Lage 7f' eintritt usw..

Die zwischen benachbarten Längsschlitzen 109 und vier Ausklinkungen 110 liegenden Abschnitte 111'' der Stege 111 bilden im Kühler 1b wieder durchgehende Pfosten 114, die sich von der oberen Kühler-Lage 5 bis an die untere Kühler-Lage 6 erstrecken und trotz der Strukturierung der Kühler-Lagen 7f und 7f' eine hohe Festigkeit für den Kühler 1b gewährleisten.

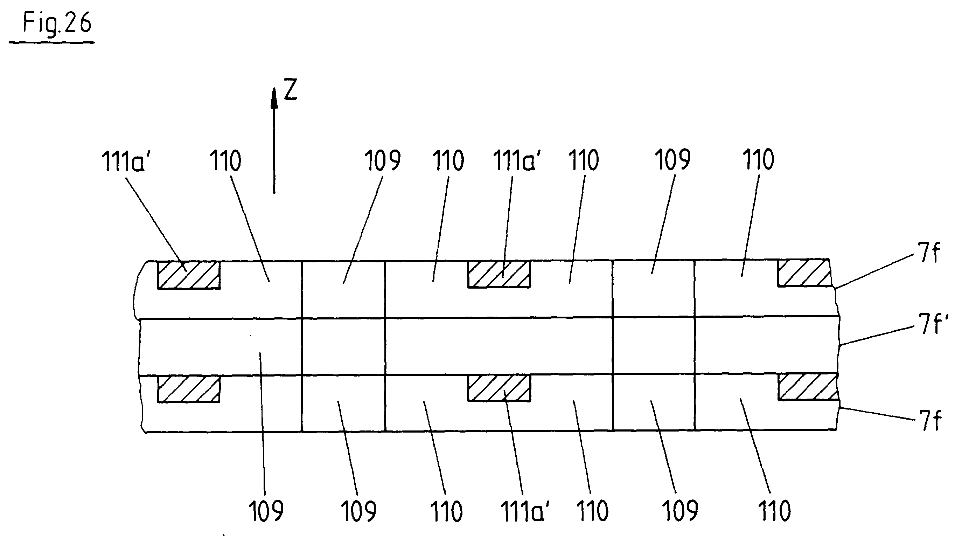

Die Figur 26 zeigt in einer Darstellung wie Figur 24 eine weitere mögliche Ausführungsform, die sich von der Ausführungsform der Figuren 24 und 25 lediglich dadurch unterscheidet, daß die zwischen zwei benachbarten Längsschlitzen 109 durch die seitichen Erweiterungen oder Ausklingen 110 gebildeten schmalen Stegabschnitte 111', die die bei der dargestellten Ausführungsform quadratischen Stegabschnitte 111'' zusammenhalten, eine verminderte Materialstärke aufweisen, wie dies in der Figur 26 für den dortigen Stegabschnitt 111a' dargestellt ist. Die Materialdicke entspricht an diesen schmalen Stegbereichen 111a' nur einem Bruchteil der Materialdicke der für die Metall-Lagen verwendeten Folie, beispielsweise nur etwa der halben Materialdicke. Bei der dargestellten Ausführungsform ist dies dadurch erzeugt, daß jeder Stegabschnitt 111a' an einer Oberflächenseite der betreffenden Metall-Lage deckungsgleich mit der Oberflächenseite und an der anderen Oberflächenseite gegenüber dieser zurückversetzt ist. Die in der Materialdicke reduzierten Stegabschnitte 111a' sind beispielsweise durch Ätzen, durch Prägen oder durch eine andere, geeignete Technik hergestellt. Durch die Reduzierung der Materialdicke an den Stegbereichen 111a' wird eine weitere Reduzierung des gesamten Strömungswiderstandes für das Kühlmedium innerhalb des jeweiligen Kühlers erreicht. Gleichzeitig sind aber die die Pfosten 114 bildenden und von dem Kühlmedium umströmten Stegabschnitte 111'' in der erforderlichen Weise miteinander und mit dem Rest der jeweiligen Metall-Lage verbunden.

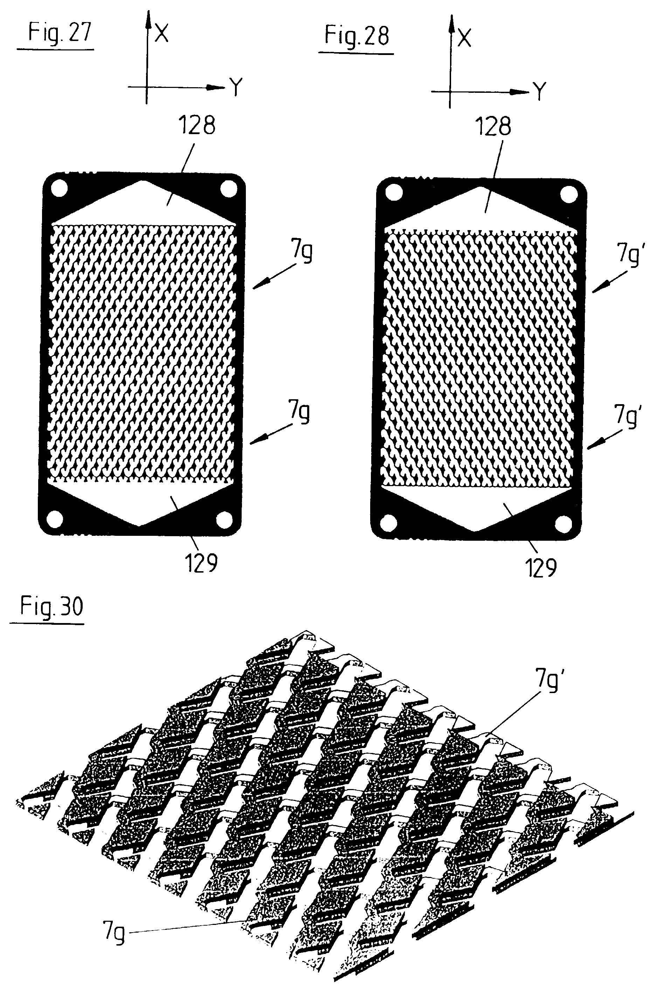

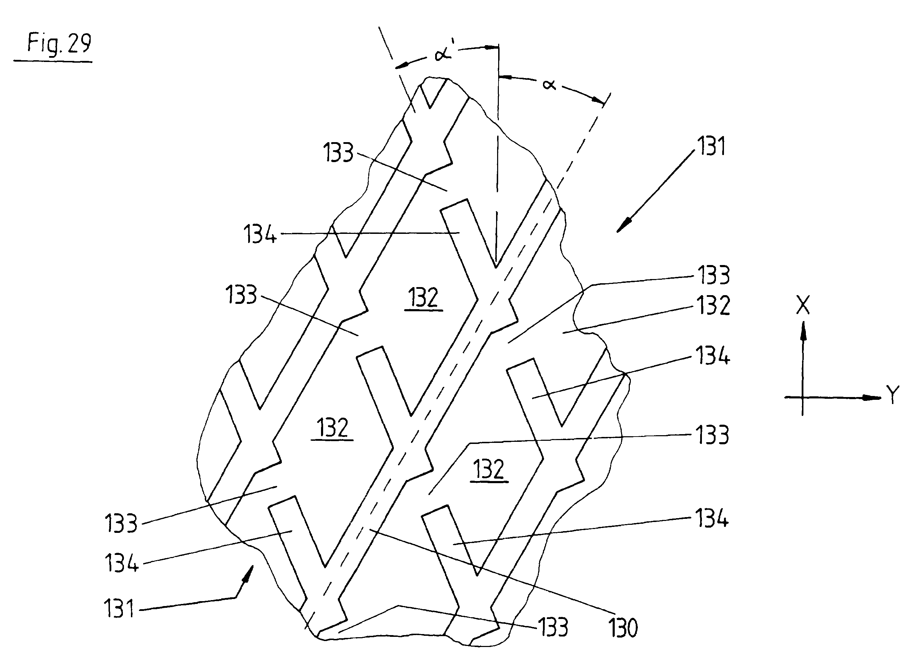

Die Figuren 27 - 30 zeigen als weitere mögliche Ausführungsform strukturierte Metall-Lagen 7g und 7g' zur Verwendung beispielsweise bei dem in der Figur 21 dargestellten Kühler 1b anstelle der dortigen Metall-Lagen 7e. Von den beiden in den Figuren 27 und 28 dargestellte Metall-Lagen ist die Metall-Lage 7g' wiederum die modifizierte bzw. invertierte Form der Metall-Lage 7g ist. Im Kühler sind dann anstelle der Metall-Lagen 7e jeweils die Metall-Lagen 7g und 7g' abwechselnd vorgesehen. Der besseren Darstellung wegen, sind in den Figuren 27 - 30 wiederum die drei Raumachsen X, Y und 7 angegeben.

Die Metall-Lagen 7g und 7g' bestehen wiederum aus einem dünnen Metallblech, beispielsweise aus einem Kupferblech oder einer Kupferfolie, wobei die Strukturierung der Metall-Lage 7g dadurch gebildet ist, daß diese Metall-Lage an zwei einander gegenüberliegenden Seiten die Öffnungen 128 und 129 aufweisen, die auch bei der Metall-Lage 7g' vorhanden sind, und zwar derart, daß bei übereinander angeordneten Metall-Lagen die Öffnungen 128 sämtlicher Metall-Lagen und auch die Öffnungen 129 sämtlicher Metall-Lagen deckungsgleich liegen und dadurch die Kammern 10 bzw. 11 des Kühlers 1b bilden. Die Öffnungen 128 und 129 sind in der in der X-Achse liegenden Längsachse der Metall-Lagen 7g und 7g' gegeneinander versetzt. Zwischen diesen Öffnungen ist die Metall-Lage 7g so strukturiert, daß diese eine Vielzahl von Schlitzen 130 aufweist, die sich schräg zur X-Achse erstrecken und mit dieser X-Achse einen Winkel α einschließen. Zwischen diesen langen Schlitzen 130 sind jeweils Reihen 131 von rautenartigen Flächenbereichen 132 gebildet, die über kurze schmale Materialstege 133 zu der jeweiligen Reihe 131 verbunden sind. Außerhalb der Stege 133 sind die einzelnen rautenartigen Flächenbereiche 132 durch kurze Schlitze 134, die schräg zu den langen Schlitzen 130 verlaufen und in diese münden, voneinander getrennt. Jeweils mehrere Schlitze 134 liegen achsgleich mit einander und schließen über die Materialstege 133 an einander an. Die Achsen der Schlitze schließen mit der X-Achse einen Winkel α' ein, der betragsmäßig gleich dem Winkel α ist, gegenüber der X-Achse aber entgegengesetzt gedreht ist.

Die Strukturierung der Metall-Lage 7g' entspricht der Strukturierung der Metall-Lage 7g und unterscheidet sich hiervon lediglich dadurch, daß die langen Schlitze 130 dort mit der X-Achse den Winkel α' einschließen, so daß bei den im Kühler aufeinander folgenden Metall-Lagen 7g und 7g' jeweils ein Schlitz 130 der Metall-Lage 7g deckungsgleich mit einer Aufeinanderfolge von Schlitzen 134 der Metall-Lage 7g' liegt.

Bei dem Kühler liegen weiterhin die Flächenbereich 132 der Metall-Lagen deckungsgleich übereinander, wobei diese Flächenbereiche 132 miteinander verbunden sind, beispielsweise unter Verwendung des DCB-Verfahrens. Die deckungsgleich angeordneten Flächenbereich 132 bilden im Kühler durchgehende Säulen. Durch die Schlitze 130 und 134 und die diese Schlitze unterbrechenden Stege 133 sind zwischen den von den Öffnungen 128 und 129 gebildeten Kammern eine Vielzahl von sich in allen drei Raumachsen verzweigenden Kühlkanälen gebildet, die ein intensives Umströmen, insbesondere auch der von den Flächenbereichen 132 gebildeten Säulen durch das wärmetransportierende Medium gewährleistet.

Durch die rautenartige Struktur der Flächenbereiche 132 und damit durch die rautenartige Struktur der Säule wird bei einem optimalen Wärmeaustausch-Austausch-Effekt zwischen dem wärmetransportierenden Medium und den Metall-Lagen ein geringer Strömungswiderstand erzielt. Es besteht die Möglichkeit, das Material der Metall-Lagen 7g und/oder 7g' im Bereich der Stege 133 zu reduzieren.

Die Erfindung wurde voranstehend an einem Ausführungsbeispiel beschrieben. Es versteht sich, daß Änderungen bzw. Abwandlungen möglich sind, ohne daß dadurch der der Erfindung zugrundeliegende Erfindungsgedanke verlassen wird.

### Bezugszeichenliste

- 1, 1a, 1b: Kühler
- 2: elektronisches bzw. elektrisches Bauelement
- 2': Isolierschicht
- 3, 3': Kühlmitteleinlaß
- 4, 4': Kühlmittelauslaß
- 5, 6, 5d, 6d: Metall-Abschlußlage
- 7, 7a, 7b: Metall-Lage
- 7c, 7e: Metall-Lage
- 8, 8a, 8b, 8c, 8d: Metall-Lage
- 9: Linie
- 10, 11: Kammer
- 12: Mikrokühlerstruktur
- 13: Pfosten
- 14: geschlossener Randbereich
- 15, 15', 15'': strukturierter Bereich
- 16: Öffnung
- 17: Steg
- 18: Insel
- 19', 19'': Öffnung
- 20: strukturierter Bereich
- 21: Öffnung
- 22: Steg
- 23: Öffnung
- 24: Steg
- 25, 27: Öffnung
- 28 - 32: Öffnung
- 33: Materialsteg
- 34: geschlossener Rand
- 35: Öffnung
- 36: Materialsteg
- 37: Verbreiterung
- 109: durchgehende Längsschlitze
- 110: seitliche Erweiterungenoder Ausklinkungen
- 111: Materialstege
- 111', 111'': Bereiche
- 112: geschlossener Rand
- 113: Materialsteg
- 114: Pfosten
- 128, 129: Öffnungen
- 130: Schlitz
- 131: Reihe
- 132: Flächenbereich
- 133: Steg
- 134: Schlitz
- A, B: Strömungsrichtung
- C, D: Achse
- c, D: Achsabstand
- X-Achse:
- Y-Achse:
- Z-Achse:

## Patentansprüche

1. Kühler zur Verwendung als Wärmesenke für elektrische oder elektronische Komponenten (2), insbesondere Bauelemente, Schaltkreise, Module, wobei der Kühler (1, 1a, 1b) wenigstens eine Kühlerfläche für elektrische oder elektronische Komponenten (2) bildet und zumindest teilweise aus mehreren stapelartig übereinander angeordneten und flächig miteinander verbundenen Kühlerlagen (5 - 8) besteht, von denen zumindest einige Lagen (7, 8) derart strukturiert sind, daß sie im Inneren des Kühlers (1, 1a, 1b) zwischen wenigstens einem Einlaß (3, 3a, 10) und wenigstens einem Auslaß (4, 4a, 11) für ein Kühlmedium bzw. wärmetransportierendes Medium wenigstens eine zumindest zweidimensionale Kühlerstruktur mit sich zumindest in zwei Raumachsen (X-Achse; Y-Achse, Z-Achse) verzweigenden Strömungswegen für das Kühlmedium bilden, **dadurch gekennzeichnet**, daß wenigstens ein Teil der die Kühlerstruktur (12) bildenden Kühlerlagen (8) derart strukturiert ist, daß in dieser Kühlerstruktur (12) jeweils das Verhältnis oder der Gradient des spezifische Strömungswiderstandes zwischen der wenigstens einen Kühlfläche näher liegenden Bereichen und von dieser Kühlfläche weiter beabstandeten Bereichen von dem wenigstens einen Einlaß (3) zu den wenigstens einen Auslaß (4) hin zunimmt.

2. Kühler nach Anspruch 1, dadurch gekennzeichnet, daß der Gradient des spezifische Strömungswiderstandes zwischen der wenigstens einen Kühlfläche näher liegenden Bereichen und von dieser Kühlfläche weiter beabstandeten Bereichen von dem wenigstens einen Einlaß (3) zu den wenigstens einen Auslaß (4) hin kontinuierlich und/oder in mehreren Stufen zunimmt.

3. Kühler nach Anspruch 1 oder 2, dadurch gekennzeichnet, daß Kühler nach Anspruch 1, dadurch gekennzeichnet, daß der spezifische Strömungswiderstand für das Kühlmedium in den der wenigstens einen Kühlerfläche entfernter liegenden Bereichen der Kühlerstruktur (12) vom Einlaß (3, 3a, 10) zum Auslaß (4, 4a, 11) hin zunimmt, und zwar vorzugsweise kontinuierlich und/oder in mehreren Stufen.

4. Kühler nach einem der vorhergehenden Ansprüche, dadurch gekennzeichnet, daß der spezifische Strömungswiderstand für das Kühlmedium in den der wenigstens einen Kühlerfläche näher liegenden Bereichen der Kühlerstruktur (12) vom Einlaß (3, 3a, 10) zum Auslaß (4, 4a, 11) hin konstant ist oder abnimmt, und zwar vorzugsweise kontinuierlich und/oder in mehreren Stufen.

5. Kühler nach einem der vorhergehenden Ansprüche, dadurch gekennzeichnet, daß an die wenigstens eine Kühlfläche anschließend zumindest ein erster Bereich der Kühlstruktur (12) von wenigstens einer ersten Kühlerlage (7) gebildet ist, der (Bereich) in Richtung vom Einlaß (3, 3', 10) zum Auslaß (4, 4', 11) einen gleichbleibenden oder sich verringernden spezifischen Strömungswiderstand für das Kühlmedium aufweist.

6. Kühler nach einem der vorhergehenden Ansprüche, dadurch gekennzeichnet, daß an den wenigstens einen ersten Bereich der Kühlstruktur (12) anschließend und von der wenigstens einen Kühlerfläche getrennt zumindest ein zweiter Bereich von wenigstens einer zweiten Kühlerlage (8) gebildet ist, an dem der spezifische Strömungswiderstand für das Kühlmedium von dem Einlaß (3, 3', 10) zum Auslaß (4, 4', 11) hin zunimmt.

7. Kühler nach einem der vorhergehenden Ansprüche, dadurch gekennzeichnet, daß an zwei Seiten, vorzugsweise an zwei einander gegenüberliegenden Seiten des Kühlers jeweils wenigstens eine Kühlerfläche gebildet ist, und daß die wenigstens eine Kühlerstruktur (12a) zwischen den Kühlflächen so ausgeführt ist, daß der spezifische Strömungswiderstand für das Kühlmedium ausgehend von einer Ebene (E) zwischen den Kühlflächen in Richtung vom Einlaß (3a) zum Auslaß (4a) jeweils zunimmt.

8. Kühler nach einem der vorhergehenden Ansprüche, dadurch gekennzeichnet, daß die Strukturierung der Kühlerlagen (7, 8) dadurch gebildet ist, daß diese Lagen mit einer Vielzahl von Durchbrüchen oder Öffnungen (16, 30, 31) mit diese umgebenden Flächenbereichen versehen sind,
wobei beispielsweise
die Kühlerlagen (7, 8) derart strukturiert sind, daß sich Durchbrüche oder Öffnungen benachbarter Kühlerlagen nur teilweise decken, so daß sich zumindest in der Kühlerstruktur (12) zwischen den einzelnen Kühlerlagen in zwei senkrecht zueinander verlaufenden Achsrichtungen, vorzugsweise in drei senkrecht zueinander verlaufenden Achsrichtungen (X-Achse, Y-Achse, Z-Achse) ständig verzweigende Strömungswege für das Kühlmedium ergeben.

9. Kühler nach einem der vorhergehenden Ansprüche, dadurch gekennzeichnet, daß die Kühlerstruktur (12) zwischen wenigstens einer ersten, durch Strukturierung der Kühlerlagen (7, 8) gebildeten und zum Zuführen des Kühlmediums dienenden Kammer (10) und einer zweiten, ebenfalls durch Strukturierung der Kühlerlagen (7, 8) gebildeten und zum Abführen des Kühlmediums dienenden Kammer (11) vorgesehen ist,wobei beispielsweise
der Einlaß (3) und/oder der Auslaß (4) über einen Verteilerabschnitt (12') mit einer Vielzahl von Kanälen mit der ersten Kammer (10) bzw. mit der zweiten Kammer (11) verbunden sind und die Kanäle durch Strukturierung (20) der Kühlerlagen (7, 8) derart erzeugt sind, daß sie sich in wenigstens zwei senkrecht zueinander verlaufenden Achsrichtungen, vorzugsweise in drei senkrecht zueinander verlaufenden Achsrichtungen verzweigen,
und/oder wobei beispielsweise
die Kühlerlagen (7, 8) in dem jeweiligen Verteilerabschnitt (12') in gleicher Weise strukturiert sind wie im Kühlerabschnitt (12).

10. Kühler nach einem der vorhergehenden Ansprüche, dadurch gekennzeichnet, daß die Kühlerlagen (7, 8) zumindest in einem Teilbereich siebartig mit einer Vielzahl von Öffnungen (16) und diese Öffnungen (16) umgebenden Materialbereichen versehen ist,
und/oder
daß bei den zweiten Kühlerlagen (8) der Anteil an geschlossener Fläche zur Fläche der Durchbrechungen oder Öffnungen von dem Einlaß (3, 3a, 10) zum Auslaß (4, 4a, 11) hin zunimmt,
und/oder
daß die Durchbrechungen oder Öffnungen (16) eine netzartige Struktur bilden, bei der die Öffnungen (16) von Ringstrukturen oder von durch Stegen (17) gebildete Polygon- oder Ringstrukturen umschlossen sind,
und/oder
daß die Strukturierung der zweiten Kühlerlagen (8) zum Auslaß hin im Querschnitt und/oder in der Anzahl reduzierte Durchbrechungen oder Öffnungen aufweist,
und/oder
daß die Strukturierung der wenigstens einen zweiten Kühlerlage dadurch gebildet ist, daß Öffnungen oder Durchbrechungen (16) der wenigstens einen ersten Kühlerlage (7) durch Materialstege (22), die hinsichtlich ihrer Breite und/oder Anzahl vom Einlaß (3, 3a, 10) zum Auslaß (4, 4a, 11) hin zunehmen, zumindest teilweise verschlossen sind,
und/oder
daß die Strukturierung der Kühlerlagen (7, 8) durch schlitzförmige Öffnungen oder Durchbrechungen (30, 31) gebildet ist, die sich von Kühlerlage zu Kühlerlage kreuzen und daß die Anzahl und/oder Breite der schlitzförmigen Öffnungen (31) der wenigstens einen zweiten Kühlerlage (8c) kleiner ist als die entsprechende Anzahl oder Breite der Öffnungen (30) in der ersten Kühlerlage (7c),
und/oder
daß die Strukturierung der Kühlerlagen (7, 8) durch schlitzförmige Öffnungen oder Durchbrechungen (30, 31) gebildet ist, die sich von Kühlerlage zu Kühlerlage kreuzen, und daß sich die Öffnungen (31) in der zweiten Kühlerlage (8c) zum Auslaß (4, 4a, 29) hin verengen.

11. Kühler nach einem der vorhergehenden Ansprüche, dadurch gekennzeichnet, daß bei sich kreuzenden schliztförmigen Strukturen bzw. Öffnungen (30) an den Kreuzungspunkten zumindest ein Teil der Strukturen bzw. Öffnungen (30) verbreitert (33) ausgeführt ist, um dem Querschnitt vergrößerte Durchlässe zwischen den in den benachbarten Kühlerlagen gebildeten Kanälen zu schaffen.

12. Kühler zur Verwendung als Wärmesenke für elektrische oder elektronische Komponenten (2), insbesondere Bauelemente, Schaltkreise, Module, wobei der Kühler (1, 1a, 1b) wenigstens eine Kühlerfläche für elektrische oder elektronische Komponenten (2) bildet und zumindest teilweise aus mehreren stapelartig übereinander angeordneten und flächig miteinander verbundenen Kühlerlagen (5 - 8) besteht, von denen zumindest einige Lagen (7, 8) derart strukturiert sind, daß sie im Inneren des Kühlers (1, 1a, 1b) zwischen wenigstens einem Einlaß (3, 3a, 10) und wenigstens einem Auslaß (4, 4a, 11) für ein Kühlmedium bzw. wärmetransportierendes Medium wenigstens eine zumindest zweidimensionale Kühlerstruktur mit sich zumindest in zwei Raumachsen (X-Achse; Y-Achse, Z-Achse) verzweigenden Strömungswegen für das Kühlmedium bilden, Kühler zur Verwendung als Wärmesenke für elektrische oder elektronische Komponenten (2), insbesondere Bauelemente, Schaltkreise, Module, wobei der Kühler (1, 1a, 1b) wenigstens eine Kühlerfläche für elektrische oder elektronische Komponenten (2) bildet und zumindest teilweise aus mehreren stapelartig übereinander angeordneten und flächig miteinander verbundenen Kühlerlagen (5 - 8) besteht, von denen zumindest einige Lagen (7, 8) derart strukturiert sind, daß sie im Inneren des Kühlers (1, 1a, 1b) zwischen wenigstens einem Einlaß (3, 3a, 10) und wenigstens einem Auslaß (4, 4a, 11) für ein Kühlmedium bzw. wärmetransportierendes Medium wenigstens eine zumindest zweidimensionale Kühlerstruktur mit sich zumindest in zwei Raumachsen (X-Achse; Y-Achse, Z-Achse) verzweigenden Strömungswegen für das Kühlmedium bilden, **dadurch gekennzeichnet**, daß die Strukturierung der Kühlerlagen (7, 8) durch schlitzförmige Öffnungen oder Durchbrechungen (35) gebildet ist, die sich von Kühlerlage zu Kühlerlage ebenso wie die zwischen den Durchbrechungen verbliebenen Materialabschnitte (36) kreuzen, und daß die Materialabschnitte an ihren Kreuzungspunkten verbreitert (37) ausgeführt ist.

13. Kühler zur Verwendung als Wärmesenke für elektrische oder elektronische Komponenten (2), insbesondere Bauelemente, Schaltkreise, Module, wobei der Kühler (1, 1a, 1b) wenigstens eine Kühlerfläche für elektrische oder elektronische Komponenten (2) bildet und zumindest teilweise aus mehreren stapelartig übereinander angeordneten und flächig miteinander verbundenen Kühlerlagen (5 - 8) besteht, von denen zumindest einige Lagen (7, 8) derart strukturiert sind, daß sie im Inneren des Kühlers (1, 1a, 1b) zwischen wenigstens einem Einlaß (3, 3a, 10) und wenigstens einem Auslaß (4, 4a, 11) für ein Kühlmedium bzw. wärmetransportierendes Medium wenigstens eine zumindest zweidimensionale Kühlerstruktur mit sich zumindest in zwei Raumachsen (X-Achse; Y-Achse, Z-Achse) verzweigenden Strömungswegen für das Kühlmedium bilden, wobei die Kühlerstruktur (12) zwischen wenigstens einer ersten, durch Strukturierung der Kühlerlagen (7, 8) gebildeten und zum Zuführen des Kühlmediums dienenden Kammer (10) und einer zweiten, ebenfalls durch Strukturierung der Kühlerlagen (7, 8) gebildeten und zum Abführen des Kühlmediums dienenden Kammer (11) vorgesehen ist, **dadurch gekennzeichnet**, daß der Einlaß (3) und/oder der Auslaß (4) über einen Verteilerstruktur (12') mit einer Vielzahl von Kanälen mit der ersten Kammer (10) bzw. mit der zweiten Kammer (11) verbunden sind, und daß die Kanäle durch Strukturierung (20) der Kühlerlagen (7, 8) derart erzeugt sind, daß sie sich in wenigstens zwei senkrecht zueinander verlaufenden Achsrichtungen, vorzugsweise in drei senkrecht zueinander verlaufenden Achsrichtungen verzweigen.

14. Kühler nach einem der vorhergehenden Ansprüche, dadurch gekennzeichnet, daß die Strukturierung der Kühlerlagen (7, 8) durch schlitzförmige Öffnungen oder Durchbrechungen (30, 31) gebildet ist, die sich von Kühlerlage zu Kühlerlage kreuzen, und daß die Öffnungen (31) in der zweiten Kühlerlage (8c) zumindest teilweise wenigstens durch einen Materialsteg (31') unterbrochen und/oder in ihrer Breite verengt sind, wobei die Breite und/oder Fläche dieser Materialstege (31') zum Auslaß (4, 4a, 29) hin zunimmt,
wobei beipielsweise die Stege durch bei der Strukturierung belassene Materialbereiche (31') gebildet sind, die sich zum Auslaß (4, 4a, 29) hin keilförmig verbreitern.

15. Kühler zur Verwendung als Wärmesenke für elektrische oder elektronische Komponenten, insbesondere Bauelemente, Schaltkreise, Module wobei der Kühler (1c) wenigstens eine Kühlerfläche für die Komponenten (2) bildet und aus mehreren stapelartig übereinander angeordneten und flächig miteinander verbundenen Kühler-Lagen (5f - 8f) besteht, von denen zumindest einige Lagen (7f, 7f') jeweils mit mehreren parallelen, voneinander beabstandeten schlitzförmigen Öffnungen (109) versehen sind, die zu einer in der Ebene der Kühler-Lagen liegenden Achsrichtung (X - Achse) schräg derart verlaufen, daß diese schlitzförmigen Öffnungen (109) benachbarter Kühler-Lagen sich von Kühler-Lage zu Kühler-Lage unter einem vorgegebenen Winkel schneiden, **dadurch gekennzeichnet**, daß die schlitzförmigen Öffnungen an den Kreuzungsstellen seitliche Erweiterungen (110) derart aufweisen, daß jede Erweiterung (110) einer Kühler-Lage einer schlitzförmigen Öffnung (109) der benachbarten Kühler-Lage benachbart liegt,
wobei beispielsweise die Erweiterungen in der Achsrichtung des jeweiligen Schlitzes (109) eine Breite aufweisen, die gleich der Breite der schlitzförmigen Öffnung außerhalb der Erweiterungen ist.

16. Kühler nach einem der vorhergehenden Ansprüche, dadurch gekennzeichnet, daß in den Kühler-Lagen (7f, 7f') zwischen benachbarten schlitzförmigen Öffnungen (109) jeweils Materialstege (111) gebildet sind, die sich aus ersten Stegabschnitten (111', 111a') und zweiten Stegabschnitten (111'') zusammensetzen, wobei die ersten Stegabschnitte (111', 111a') in Richtung senkrecht zur Längserstreckung der schlitzförmigen Öffnungen (109) der Kühlerlage (7f, 7f') eine kleinere Breite aufweisen als die zweiten Stegabschnitte (111''), und daß die zweiten Stegabschnitte (111'') jeweils über wenigstens einen ersten Stegabschnitt (111', 111a') miteinander verbunden sind.

17. Kühler nach einem der vorhergehenden Ansprüche, dadurch gekennzeichnet, daß jeder erste Stegabschnitt (111', 111a') von wenigstens einer seitlichen Erweiterung (110) wenigstens einer benachbarten schlitzförmigen Öffnung (109) und/oder zwischen zwei Erweiterungen (110) zweier benachbarter schlitzförmiger Öffnungen (109) gebildet ist.

18. Kühler nach einem der vorhergehenden Ansprüche, dadurch gekennzeichnet, daß zumindest einige Kühlerlagen (7f, 7f') im Bereich der ersten Steg-Abschnitte (111a') eine reduzierte Materialdicke, beispielsweise eine um die Hälfte reduzierte Materialdicke aufweisen.

19. Kühler zur Verwendung als Wärmesenke für elektrische und elektronische Komponenten, insbesondere elektrische Bauelemente, Schaltkreise, Module, wobei der Kühler aus mehreren stapelartig übereinander angeordneten und flächig miteinander verbundenen Kühlerlagen besteht, von denen zumindest einigen Lagen (7g, 7g') jeweils mit mehreren ersten schlitzförmigen Öffnungen (130) versehen sind, die parallelen zu einander und voneinander beabstandent sind und zu einer in der Ebene der Kühlerlagen liegenden Achsrichtung (X-Achse) schräg derart verlaufen, daß diese ersten Öffnungen (130) sich von Kühlerlage zu Kühlerlage unter einem vorgegebenen Winkel schneiden, **dadurch gekennzeichnet**, daß zwischen den ersten schlitzförmigen Öffnungen (130) Reihen von Flächenbereichen (132) vorgesehen sind, die in einer Achsrichtung der ersten schlitzförmigen Öffnungen (130) aneinander anschließen und die in jeder Reihe durch zweite Schlitze (134) voneinander getrennt und nur über Materialstege (133) miteinander verbunden sind.

20. Kühler nach Anspruch 33, dadurch gekennzeichnet, daß die zweiten Schlitze (134) zumindest mit einem Ende in jeweils einen ersten Schlitz (130) münden,
und/oder
daß jeweils mehrere zweite Schlitze (134) achsgleich angeordnet sind und über jeweils wenigstens einen Steg (133) aneinander anschließen,
und/oder
daß die Flächenbereiche (132) rautenartig oder quadratisch ausgebildet sind.

21. Kühler nach einem der vorhergehenden Ansprüche, dadurch gekennzeichnet, daß die Kühlerlagen (7, 8) derart strukturiert sind, daß Flächenbereiche (18) dieser Kühlerlagen sich senkrecht zu der Ebene der Lagen erstreckende durchgehende Pfosten (13) bilden, insbesondere in der Kühlerstruktur (12) und/oder in der jeweiligen Verteilerstruktur (12').
